# EUROPEAN PATENT APPLICATION

(11) **EP 4 852 682 A1**
(43) Date of publication of application: **09.12.2026**
(21) Application number: 24953501.4
(22) Date of filing: 20.09.2024
(51) Int. Cl.: H10K 59/80, H10K 59/60, H10K 50/80, H10K 59/131

(54) **DISPLAY PANEL AND DISPLAY APPARATUS HAVING SAME**

(30) Priority: 09.09.2024 CN 202411262703
(71) Applicant: Wuhan Tianma Microelectronics Co., Ltd., Wuhan, Hubei 430205 (CN)
(72) Inventor: LIU, Yanzi, Wuhan, Hubei 430205 (CN)
(74) Representative: Völkl Siebenson Patentanwälte - Partnerschaft mbB
(86) International application number: PCT/CN2024/120017
(87) International publication number: WO 2026/051115

(57) **Abstract**

A display panel. The display panel comprises a display area and a non-display area, the non-display area at least partially surrounding the display area. The display area comprises a main display area and an auxiliary display area, the main display area at least partially surrounding the auxiliary display area. The auxiliary display area contains a light-transmitting hole, the light-transmitting hole being used for transmitting a light ray to a photosensitive element. The display panel further comprises a substrate and a plurality of signal lines. The signal lines comprise a first signal line, the first signal line extending in a first direction and comprising a first cut. In a second direction, the orthographic projection of the first cut on the substrate overlaps the orthographic projection of the light-transmitting hole on the substrate, the first direction intersecting the second direction.

## Description

This application claims priority to Chinese Patent Application No. 202411262703.1 filed with the China National Intellectual Property Administration (CNIPA) on Sep. 9, 2024, the disclosure of which is incorporated herein by reference in its entirety.

### TECHNICAL FIELD

Embodiments of this application relate to the field of display technology, for example, a display panel and a display device.

### BACKGROUND

With the continuous development of display technology, display panels have been widely applied in people's work and life. The display panel may be adjusted to better meet user demands, for example, the wiring in the display panel is modified, thereby improving the overall performance of the display panel.

### SUMMARY

In a first aspect, embodiments of this application provide a display panel. The display panel includes a display region and a non-display region. The non-display region at least partially surrounds the display region.

The display region includes a main display region and an auxiliary display region. The main display region at least partially surrounds the auxiliary display region. The auxiliary display region includes a light-transmissive aperture through which light is allowed to pass to a photosensitive element.

The display panel also includes a substrate and multiple signal lines. The signal lines include a first signal line. The first signal line extends in a first direction. The first signal line has a first break. In a second direction, the orthographic projection of the first break on the substrate overlaps the orthographic projection of the light-transmissive aperture on the substrate.

The first direction intersects the second direction.

In a second aspect, embodiments of this application provide a display device. The display device includes the display panel of the first aspect.

The display device also includes the photosensitive element.

In the thickness direction of the display device, the light-transmissive aperture overlaps the photosensitive element.

### BRIEF DESCRIPTION OF DRAWINGS

FIG. 1 is a first diagram illustrating the structure of a display panel according to embodiments of this application.
FIG. 2 is a first enlarged view of an auxiliary display region according to embodiments of this application.
FIG. 3 is a second enlarged view of an auxiliary display region according to embodiments of this application.
FIG. 4 is an enlarged view of region B of FIG. 1.
FIG. 5 is a first section view taken along line C-C' of FIG. 4.
FIG. 6 is a second section view taken along line C-C' of FIG. 4.
FIG. 7 is a first enlarged view of an auxiliary display region according to embodiments of this application.
FIG. 8 is a second enlarged view of an auxiliary display region according to embodiments of this application.
FIG. 9 is a second diagram illustrating the structure of a display panel according to embodiments of this application.
FIG. 10 is a diagram illustrating a film layer arrangement of auxiliary lines according to embodiments of this application.
FIG. 11 is a third enlarged view of an auxiliary display region according to embodiments of this application.
FIG. 12 is a fourth enlarged view of an auxiliary display region according to embodiments of this application.
FIG. 13 is a fifth enlarged view of an auxiliary display region according to embodiments of this application.
FIG. 14 is a sixth enlarged view of an auxiliary display region according to embodiments of this application.
FIG. 15 is a seventh enlarged view of an auxiliary display region according to embodiments of this application.
FIG. 16 is a third diagram illustrating the structure of a display panel according to embodiments of this application.
FIG. 17 is a fourth diagram illustrating the structure of a display panel according to embodiments of this application.
FIG. 18 is a fifth diagram illustrating the structure of a display panel according to embodiments of this application.
FIG. 19 is a first diagram illustrating the structure of a pixel circuit according to embodiments of this application.
FIG. 20 is a timing diagram of signals provided for the pixel circuit of FIG. 19 in one drive cycle according to embodiments of this application.
FIG. 21 is a second diagram illustrating the structure of a pixel circuit according to embodiments of this application.
FIG. 22 is a timing diagram of signals provided for the pixel circuit of FIG. 21 in one drive cycle according to embodiments of this application.
FIG. 23 is a first enlarged view of region D of FIG. 1.
FIG. 24 is a second enlarged view of region D of FIG. 1.
FIG. 25 is a third enlarged view of region D of FIG. 1.
FIG. 26 is a fourth enlarged view of region D of FIG. 1.
FIG. 27 is a fifth enlarged view of region D of FIG. 1.
FIG. 28 is an eighth enlarged view of an auxiliary display region according to embodiments of this application.
FIG. 29 is an enlarged view of region B of FIG. 1.
FIG. 30 is a section view taken along line F-F' of FIG. 29.
FIG. 31 is a diagram illustrating the structure of a display device according to embodiments of this application.

### DETAILED DESCRIPTION

The terms such as "first" and "second" in the description, claims and drawings of this application are used for distinguishing between similar objects and are not necessarily used for describing a particular order or sequence. It is understood that data used in this manner are interchangeable where appropriate so that embodiments of this application described herein can be implemented in an order not illustrated or described herein. Additionally, terms "including", "having", and any variations thereof are intended to encompass a non-exclusive inclusion. For example, in addition to a process, method, system, product, or device that includes a series of steps or units and that is shown in embodiments of this application, other processes, methods, systems, products, or devices that include the series of steps or units and that are not expressly listed, or other steps or units that are inherent to such processes, methods, systems, products, or devices, may also be included.

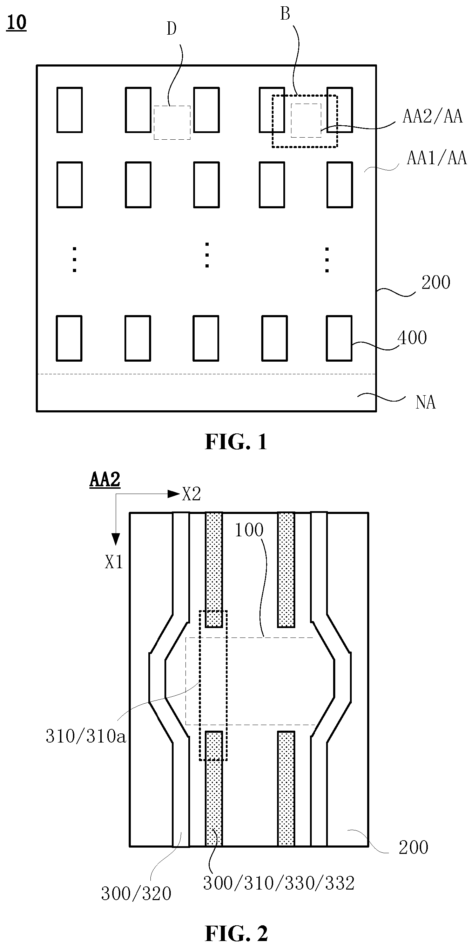

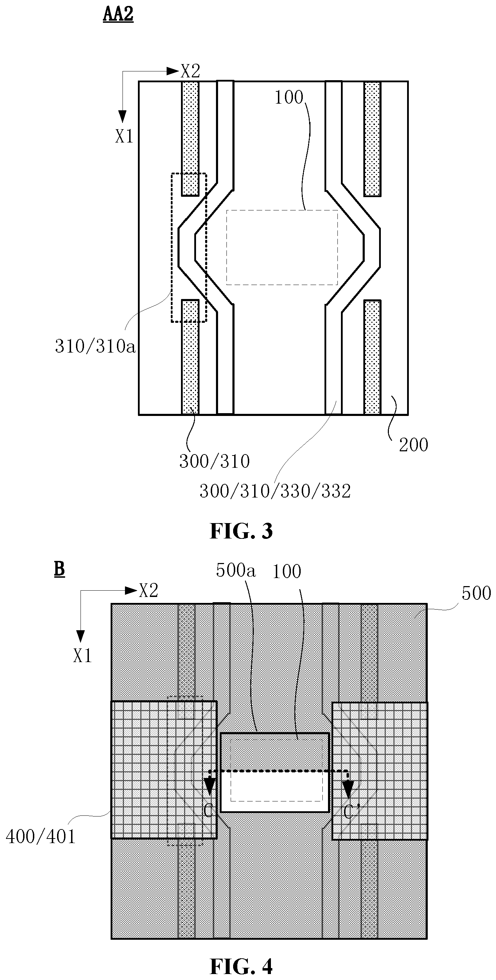

FIG. 1 is a first diagram illustrating the structure of a display panel according to embodiments of this application. FIG. 2 is a first enlarged view of an auxiliary display region according to embodiments of this application. FIG. 3 is a second enlarged view of an auxiliary display region according to embodiments of this application. As shown in FIG. 1 to FIG. 3, embodiments of this application provide a display panel 10. The display panel 10 includes a display region AA and a non-display region NA. The non-display region NA at least partially surrounds the display region AA. The display region AA includes a main display region AA1 and an auxiliary display region AA2. The main display region AA1 at least partially surrounds the auxiliary display region AA2. The auxiliary display region AA2 includes a light-transmissive aperture 100 through which light is allowed to pass to a photosensitive element. The display panel 10 also includes a substrate 200 and multiple signal lines 300. The signal lines 300 include a first signal line 310. The first signal line 310 extends in a first direction X1. The first signal line 310 has a first break 310a. In a second direction X2, the orthographic projection of the first break 310a on the substrate 200 overlaps the orthographic projection of the light-transmissive aperture 100 on the substrate 200. The first direction X1 intersects the second direction X2.

As shown in FIG. 1, the display panel 10 includes the display region AA and the non-display region NA. The display region AA includes light-emitting elements 400 and signal lines connected to the light-emitting elements 400, thereby achieving the display function of the display panel 10. The non-display region NA includes a display controller, such as a driver chip. The display controller may be electrically connected to some signal lines located in the display region AA. For example, using data signal lines as an example, the display controller may provide display signals to data signal lines in the display region AA, thereby driving the display panel 10 to implement the display function. The non-display region NA surrounds at least part of the display region AA, based on positions of the display region AA and the non-display region NA, which is not limited in embodiments of this application.

In embodiments, as shown in FIG. 1, the display region AA includes the main display region AA1 and the auxiliary display region AA2. The main display region AA1 at least partially surrounds the auxiliary display region AA2. The auxiliary display region AA2 includes light-transmissive apertures 100 through which light is allowed to pass to photosensitive elements. In the thickness direction of the display panel 10, the number of photosensitive elements corresponding to the light-transmissive apertures 100 varies and is not described in detail in embodiments of this application. The main display region AA1 and the auxiliary display region AA2 can be understood as follows: the main display region AA1 is configured to implement the main display function of the display panel 10; and the auxiliary display region AA2 is configured to not only implement the display function of the display panel 10, but also satisfy the light-transmission requirements of the display panel 10. It should be noted that in FIG. 1, for purpose of clearly illustrating the relative positional relationship between the main display region AA1 and the auxiliary display region AA2, signal lines electrically connected to the light-emitting elements 400 are not shown in FIG. 1. The arrangement of the auxiliary display region AA2 in the display region AA is diverse and flexible. FIG. 1 illustrates an example of the relative positional relationship between the main display region AA1 and the auxiliary display region AA2. In different display panels 10, the positions of the light-transmissive apertures 100 vary with the positions of the photosensitive elements. Therefore, the relative positional relationship between the main display region AA1 and the auxiliary display region AA2 is also diverse. It is understood that multiple light-transmissive apertures 100 may be disposed in the auxiliary display region AA2 to increase light transmittance.

In embodiments, the photosensitive element may be understood as an optical sensor. External light may be transmitted to the photosensitive element through the light-transmissive aperture of the display panel 10. By way of example, the photosensitive element may be an under-display camera, a fingerprint recognition module, an ambient light sensor, or an infrared sensor. External light is transmitted to the photosensitive element through the light-transmissive aperture 100. Then the photosensitive element operates based on the external light. This is not limited in embodiments of this application. The light-transmissive aperture 100 can be understood as follows: in anywhere of the light-transmissive aperture 100, external light can be transmitted to the region of the photosensitive element. That is, the amount of luminous flux that can be transmitted to the light-transmissive aperture 100 affects the light transmittance of the display panel 10.

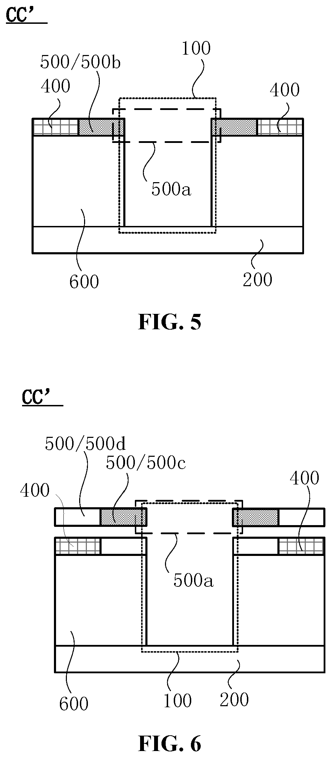

FIG. 4 is an enlarged view of region B of FIG. 1. FIG. 5 is a first section view taken along line C-C' of FIG. 4. FIG. 6 is a second section view taken along line C-C' of FIG. 4. As shown in FIG. 4 to FIG. 6, the display panel 10 also includes a light-shielding layer 500. The light-shielding layer 500 includes at least one opening 500a. In the thickness direction of the display panel 10, the opening 500a of the light-shielding layer 500 overlaps the light-transmissive aperture 100. In the thickness direction of the display panel 10, the opening 500a partially or completely overlaps the light-transmissive aperture 100, which is not limited in embodiments of this application. In the light-shielding layer 500, the region without the opening 500a can block light while the opening 500a allows light transmission. That is, light can pass through the opening 500a to reach the light-transmissive aperture 100 and then be transmitted to the photosensitive element.

In embodiments, as shown in FIG. 5, the light-shielding layer 500 can be understood as a pixel defining layer 500b that blocks light. The pixel defining layer 500b defines the size of the first electrode 401 (that is, the anode) in the light-emitting element 400. The pixel defining layer 500b can block light. Part of the pixel defining layer 500b is opened, to form the opening 500a that is arranged corresponding to the light-transmissive aperture 100. The opening 500a can allow light to be transmitted to the photosensitive element.

In embodiments, as shown in FIG. 6, the light-shielding layer 500 may be located on the side of the light-emitting elements 400 facing away from the substrate 200. The light-shielding layer 500 includes a black matrix 500c and a filter layer 500d. The filter layer 500d may include filter layers of different colors. The black matrix 500c is designed with an opening so that the light-shielding layer 500 is provided with the opening 500a that is arranged corresponding to the light-transmissive aperture 100. The opening 500a can allow light to be transmitted to the photosensitive element.

In embodiments, the light-transmissive aperture 100 shown in FIG. 5 and FIG. 6 are formed by hollowing out all film layers 600 on one side of the substrate 200. The film layers 600 may include an array layer, which is not enumerated in embodiments of this application. Alternatively, the light-transmissive aperture 100 may be formed by hollowing out some of the film layers 600. The configuration of the light-transmissive aperture 100 may be adapted to different display panels 10 or to different corresponding photosensitive elements, which is not limited in embodiments of this application. It is understood that in some embodiments, only the light-shielding layer 500 is hollowed out, that is, the opening is provided only in the light-shielding layer 500, to form the light-transmissive aperture 100.

The luminous flux transmitted to the photosensitive element through the light-transmissive aperture 100 is related to the wiring around the light-transmissive aperture 100 in the thickness direction of the display panel 10 or to the light-shielding structure surrounding the light-transmissive aperture 100. In FIG. 2 and FIG. 3, the dashed rectangular box indicates the light-transmissive aperture 100 by way of example. The shape and size of the light-transmissive aperture 100 are not limited in embodiments of this application. It is feasible to adjust the luminous flux transmitted to the light-transmissive aperture 100, that is, to adjust the structures that block light, thereby improving the light transmittance of the light-transmissive aperture 100 and thus achieving adjustment of the light transmittance of the display panel 10.

For example, reference is made to FIG. 2 and FIG. 3, which are each an enlarged view of the auxiliary display region AA2 according to embodiments of this application. By way of example, the display panel 10 includes a substrate 200 and signal lines 300. The signal lines 300 are disposed on one side of the substrate 200. The signal lines 300 include first signal lines 310 extending in the first direction. The first signal line 310 has a first break 310a. That is, the first signal line 310 is broken at the first break 310a, or the first signal line 310 is an incomplete line with a break in the first direction X1. The orthographic projection of the first break 310a of the first signal line 310 on the substrate 200 is adjacent to or intersects the orthographic projection of the light-transmissive aperture 100 on the substrate 200, which is equivalent to that the line that would block the light-transmissive aperture 100 is broken. In this manner, the arrangement of the first break 310a can increase the light transmittance of the light-transmissive aperture 100, that is, reduce the impact of the wiring on the light transmittance of the light-transmissive aperture 100, thereby improving the light transmittance at the light-transmissive aperture 100 of the display panel 10 and enhancing the ability of the display panel 10 to capture external light.

By way of example, as shown in FIG. 2 and FIG. 3, in the second direction X2, the orthographic projection of the first break 310a on the substrate 200 overlaps the orthographic projection of the light-transmissive aperture 100 on the substrate 200. That is, when the orthographic projection of the first break 310a on the substrate 200 is compared with the orthographic projection of the light-transmissive aperture 100 on the substrate 200, the two orthographic projections overlap each other in the second direction X2. Alternatively, this can be understood as that, as shown in FIG. 2 and FIG. 3, in a plan view (top view) ignoring the positional relationship between layers accommodating the first signal line 310 and the light-transmissive aperture 100, the first break 310a of the first signal line 310 overlaps the light-transmissive aperture 100 in the second direction X2, thereby directly or indirectly increasing the light transmittance of the light-transmissive aperture 100.

In embodiments of this application, "overlap" is understood as "at least partially overlap", that is, partially overlap or completely coincide, which is not repeated hereinafter.

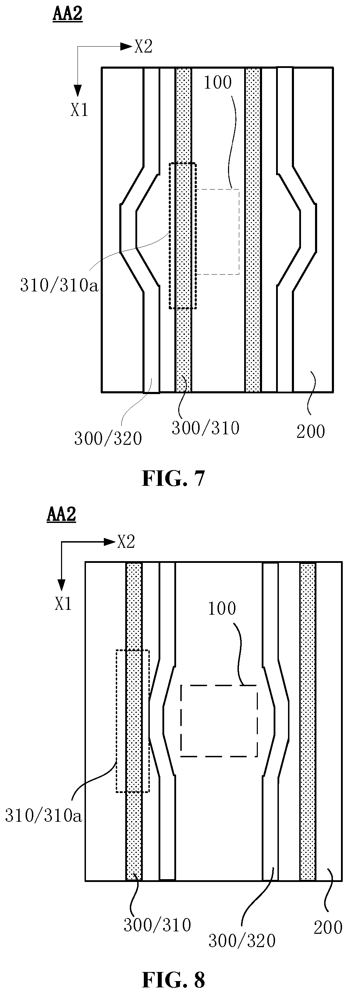

FIG. 7 is a first enlarged view of an auxiliary display region according to embodiments of this application. FIG. 8 is a second enlarged view of an auxiliary display region according to embodiments of this application. As shown in FIG. 7 and FIG. 8, in embodiments, if the first signal line 310 is not broken at the position of the first break 310a which is however provided with part of wiring, light transmitted to the light-transmissive aperture 100 would be blocked by this part of wiring, and the light transmittance of the light-transmissive aperture 100 would be affected. By way of example, in the comparison between FIG. 7 and FIG. 2, if the first signal line 310 is not broken at the first break 310a, light transmission through the light-transmissive aperture 100 is affected by the part of wiring at the first break 310a, and the light transmittance at the light-transmissive aperture 100 is reduced (with reference to the comparison between the size of the rectangular box of FIG. 7 and the size of the rectangular box of FIG. 2). Alternatively, in the comparison between FIG. 8 and FIG. 3, if the first signal line 310 is not broken at the first break 310a, other wiring would be affected; thus, the light transmittance of the light-transmissive aperture 100 is indirectly affected, and the overall light transmittance of the display panel 10 is thereby affected.

To improve the light transmittance of the display panel 10, that is, to increase the light transmittance of the light-transmissive aperture 100, part of wiring blocking the light transmitted to the light-transmissive aperture 100 is broken, that is, the first break 310a is formed on the first signal line 310; thus the overall light transmittance of the display panel 10 is ensured. In embodiments, with the continuous development of the display panel 10, the display panel 10 has more functions. Accordingly, the display panel 10 is provided with more lines of more types. Therefore, improving light transmittance by rerouting the wiring layout has its limitations.. In the embodiments of the application, the light transmittance of the light-transmissive aperture 100 can be improved by simply breaking the line blocking light passing through the transmissive aperture 100, with no wiring position adjustment and no consideration into wiring space, thereby improving the overall transmittance of the display panel 10. By way of example, as shown in FIG. 2, the first signal line 310 is broken at the first break 310a, directly increasing the light transmittance of the light-transmissive aperture 100 and enhancing the light transmittance of the display panel 10. By way of example, as shown in FIG. 3, the first signal line 310 is broken at the first break 310a so that when a line adjacent to the light-transmissive aperture 100 is disposed in the same layer as the first signal line 310, the line may be extended or bent towards the first break 310a, thereby increasing the light transmittance of the light-transmissive aperture 100 and enhancing the light transmittance of the display panel 10.

From the above, in the display panel of embodiments of this application, the first signal line is broken, the orthographic projection of the first break on the substrate overlaps the orthographic projection of the light-transmissive aperture on the substrate in the second direction, that is, the first break is in proximity with or adjacent to the light-transmissive aperture, thereby increasing the light transmittance of the display panel at the light-transmissive aperture and improving the ability of the display panel to capture external light.

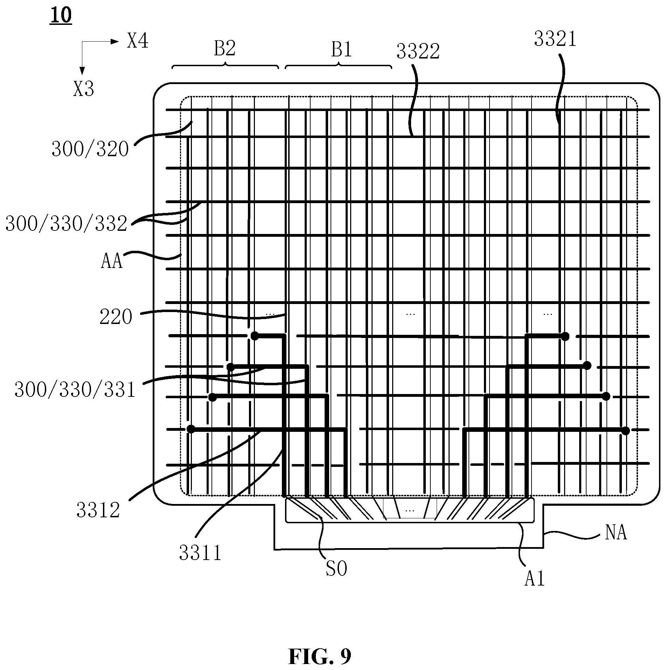

FIG. 9 is a second diagram illustrating the structure of a display panel according to embodiments of this application. As shown in FIG. 2, FIG. 3, and FIG. 9, the signal lines 300 also include multiple data signal lines 320 extending in a third direction X3 and arranged in a fourth direction X4. The third direction X3 intersects the fourth direction X4. The signal lines 300 also include multiple auxiliary lines 330. The non-display region NA includes a fan-out region A1 located on one side of the display region AA. The fan-out region A1 includes multiple fan-out lines S0. The auxiliary lines 330 include a data auxiliary line 331. At least part of the data auxiliary line 331 is located in the display region AA. At least a subset of the data signal lines 320 are electrically connected to fan-out lines S0 through data auxiliary lines 331. The auxiliary lines 330 also include a dummy auxiliary line 332 located in the display region AA. The dummy auxiliary line 332 and the data auxiliary line 331 are disposed in the same layer and insulated from each other. The first signal line 310 includes the dummy auxiliary line 332.

By way of example, as shown in FIG. 1 and FIG. 9, the signal lines 300 include data signal lines 320 extending in the third direction X3 and arranged in the fourth direction X4. The third direction X3 may be understood as the column direction of FIG. 9. The fourth direction X4 may be understood as the row direction of FIG. 9. The data signal lines 320 are configured to transmit data signals, ensuring the display function of the display panel 10. In embodiments, as shown in FIG. 9, the display panel 10 also includes the fan-out region A1 in the non-display region NA. The fan-out region A1 includes multiple fan-out lines S0. The fan-out lines S0 are electrically connected to multiple data signal lines 320 to ensure the stable transmission of data signals.

In embodiments, the signal lines 300 also include multiple auxiliary lines 330. The auxiliary lines 330 include a data auxiliary line 331. One end of the data auxiliary line 331 may be electrically connected to a fan-out line S0, while the other end of the data auxiliary line 331 may be electrically connected to a data signal line 320 extending away from the fan-out region A1 in the fourth direction X4. This ensures that the data signal lines 320 away from the fan-out region A1 can indirectly acquire data signals without being directly electrically connected to the fan-out lines S0 in the fan-out region A1. This reduces the area occupied by the fan-out region A1, effectively reduces the proportion of the non-display region NA, increases the proportion of the display region AA in the display panel 10, and enhances the display effect of the display panel 10.

By way of example, the display region AA includes multiple data signal lines 320. A subset of the data signal lines 320 may be directly electrically connected to the fan-out lines S0 in the fan-out region A1. As shown in FIG. 9, the data signal lines 320 in region B1 are closer to the fan-out lines S0 and may be directly electrically connected to the fan-out lines S0. In embodiments, a subset of the data signal lines 320 may be electrically connected to the fan-out lines S0 through the data auxiliary lines 331. As shown in FIG. 9, in the fourth direction X4, the data signal lines 320 in region B2 are farther from the fan-out region A1 than the data signal lines 320 in region B1. That is, the data signal lines 320 in region B2 are closer to the edge of the display panel 10. The data signal lines 320 in region B2 may be electrically connected to the fan-out lines S0 through the data auxiliary lines 331. This can reduce the space occupied by the fan-out lines S0, reduce the area occupied by the fan-out region A1, effectively reduce the proportion of the non-display region NA, increase the proportion of the display region AA in the display panel 10, and enhance the display effect of the display panel 10.

In embodiments, the auxiliary lines 330 also include the dummy auxiliary line 332 located in the display region AA. The dummy auxiliary line 332 is in the same layer as the data auxiliary line 331. By providing the dummy auxiliary line 332 in the display panel 10, the balance of the wiring arranged on the display panel 10 can be ensured. The dummy auxiliary line 332 is insulated from the data auxiliary line 331. That is, the dummy auxiliary line 332 does not affect the normal transmission of data signals in the data auxiliary line 331. In general, the dummy auxiliary line 332 enables the data auxiliary line 331 to achieve wiring balance in the overall wiring arrangement of the display panel 10, ensure a uniform wiring density in different regions, and thus avoid an unbalanced display effect of the display panel 10 due to different light reflectivities across the display panel 10 caused by unbalanced wiring.

In embodiments, as shown in FIG. 2 and FIG. 3, the first signal line 310 may include the dummy auxiliary line 332. The first signal line 310 has the first break 310a. The dummy auxiliary lines 332 used for achieving the wiring uniformity may also be provided with breaks. That is, the dummy auxiliary lines 332 adjacent to the light-transmissive aperture 100 may be provided with breaks to ensure the light transmittance of the light-transmissive aperture 100 and improve the overall light transmittance of the display panel 10. Therefore, the first signal line 310 may include the dummy auxiliary line 332, which does not affect the display effect of the display panel 10 while improving the ability of the display panel 10 to capture external light. In addition, the dummy auxiliary lines 332 may transmit fixed-potential signals.

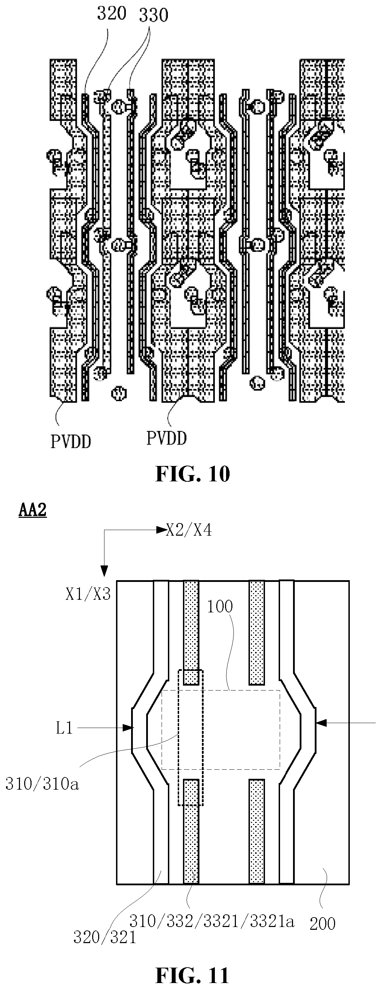

In embodiments, FIG. 10 is a diagram illustrating a film layer arrangement of auxiliary lines according to embodiments of this application. As shown in FIG. 10, the auxiliary lines 330 shown in FIG. 10 may be data auxiliary lines 331 and/or dummy auxiliary lines 332, which is not limited in embodiments of this application. As shown in FIG. 10, in the film layer where the auxiliary lines 330 are located, there are also data signal lines 320 extending in the same direction as the auxiliary lines 330. Additionally, there are power signal lines (illustrated in FIG. 10 by using an example of PVDD). To ensure the transmission of the power signals in the power signal lines, generally the widths of the power signal lines are set relatively large. Thus, in the film layer shown in FIG. 10, the space for accommodating the signal lines 300 is relatively tight, without much room for rerouting lines. As a result, it becomes difficult to prevent the lines from blocking the light transmitted to the light-transmissive aperture 100. In the display panel of embodiments of this application, the dummy auxiliary lines 332 adjacent to the light-transmissive aperture 100 are broken to improve the light transmittance of the light-transmissive aperture 100.

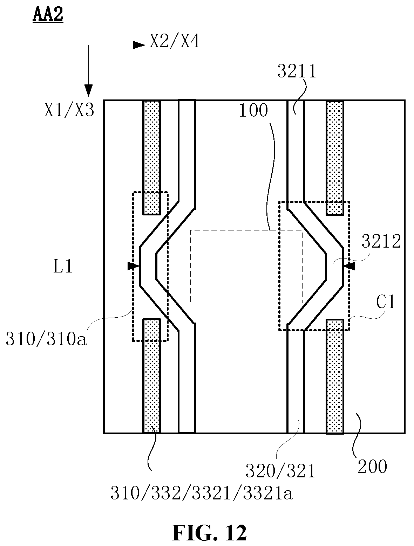

FIG. 11 is a third enlarged view of an auxiliary display region according to embodiments of this application. FIG. 12 is a fourth enlarged view of an auxiliary display region according to embodiments of this application. Referring to FIG. 9, FIG. 11, and FIG. 12, the data auxiliary line 331 includes a first data auxiliary line 3311 and a second data auxiliary line 3312 electrically connected to each other, the first data auxiliary line 3311 extends in the third direction X1 and is electrically connected to a fan-out line S0, and the second data auxiliary line 3312 extends in the fourth direction X4 and is electrically connected to a data signal line 320. A dummy auxiliary line 332 include a first dummy auxiliary line 3321 and a second dummy auxiliary line 3322 connected to each other, the first dummy auxiliary line 3321 extends in the third direction X1, the second dummy auxiliary line 3322 extends in the fourth direction X4, the first dummy auxiliary line 3321 and the first data auxiliary line 3311 are disposed in the same layer and insulated from each other, and the second dummy auxiliary line 3322 and the second data auxiliary line 3312 are disposed in the same layer and insulated from each other. The first signal line 310 includes at least part of the first dummy auxiliary line 3321, the first direction X1 and the third direction X3 are the same direction, and the second direction X2 and the fourth direction X4 are the same direction.

As shown in FIG. 9, the data auxiliary line 331 includes the first data auxiliary line 3311 and the second data auxiliary line 3312 electrically connected to each other. The extension direction of the first data auxiliary line 3311 is the same as the extension direction of the data signal line 320. The extension direction of the second data auxiliary line 3312 intersects the extension direction of the data signal line 320. In region B2 of FIG. 9, a subset of the data signal lines 320 are first electrically connected to the second data auxiliary lines 3312 extending in the fourth direction X4. The second data auxiliary lines 3312 are electrically connected to the first data auxiliary lines 3311 extending in the third direction X3. The first data auxiliary lines 3311 are electrically connected to the fan-out lines S0 in the fan-out region A1. This enables data signals in the fan-out lines S0 to be transmitted to the data signal lines 320 through the data auxiliary lines 331.

In embodiments, as shown in FIG. 9, the dummy auxiliary line 332 includes the first dummy auxiliary line 3321 and the second dummy auxiliary line 3322 electrically connected to each other. The first dummy auxiliary line 3321 extends in the same direction as the first data auxiliary line 3311. The first dummy auxiliary line 3321 is insulated from the first data auxiliary line 3311. The second dummy auxiliary line 3322 extends in the same direction as the second data auxiliary line 3311. The second dummy auxiliary line 3322 is insulated from the second data auxiliary line 3312. With the first dummy auxiliary line 3321 and the first data auxiliary line 3311, the wiring arrangement of the display panel 10 can be balanced in both the third direction X3 and the fourth direction X4, ensuring that the wiring density is uniform across different regions. This prevents an unbalanced display effect of the display panel 10 due to different light reflectivities across the display panel 10 caused by unbalanced wiring.

In embodiments, as shown in FIG. 11 and FIG. 12, the third direction X3 may be the same as the first direction X1, and the fourth direction X4 may be the same as the second direction X2. In this case, the first signal lines 310 may be understood as extending in the third direction X3. The first dummy auxiliary line 3321 is a dummy auxiliary line 332 and extends in the third direction X3. Therefore, the first dummy auxiliary line 3321 may be at least partially located in the auxiliary display region AA2. Thus, the first signal line 310 includes at least part of the first dummy auxiliary line 3321. That is, the first signal line 310 includes the part of the first dummy auxiliary line 3321 located in the auxiliary display region AA2.

With continued reference to FIG. 11 and FIG. 12, the data signal lines 320 include a first data signal line 321. At least part of the first data signal line 321 is located in the auxiliary display region AA2. Moreover, the first dummy auxiliary line 3321 include a first dummy auxiliary sub-line 3321a. At least part of the first dummy auxiliary sub-line 3321a is located in the auxiliary display region AA2. The first data signal line 321 is adjacent to the first dummy auxiliary sub-line 3321a.

That the data signal lines 320 include the first data signal line 321, and at least part of the first data signal line 321 being located in the auxiliary display region AA2 may be understood as that the display panel 10 includes multiple data signal lines 320 extending in the third direction X3, the multiple data signal lines 320 including a first data signal line, and part of the first data signal line 321 is located in the auxiliary display region AA2, that is, the first data signal line 321 is closer to the light-transmissive aperture 100 than other data signal lines 320. Therefore, the first data signal line 321 may affect the light transmittance of the light-transmissive aperture 100 in the auxiliary display region AA2.

By way of example, as shown in FIG. 11 and FIG. 12, when the first signal line 310 is a first dummy auxiliary line 3321, the first dummy auxiliary line 3321 includes a first dummy auxiliary sub-line 3321a, that is, the first dummy auxiliary sub-line 3321a can be understood as a line structure located on both sides of the first break 310a in the third direction X3. In embodiments, as shown in FIG. 11 and FIG. 12, the auxiliary display region AA2 includes at least part of the first dummy auxiliary sub-line 3321a and at least part of the first data signal line 321. The first data signal line 321 is adjacent to the first dummy auxiliary sub-line 3321a. Through adjustment of the relative position between the first data signal line 321 and the first dummy auxiliary sub-line 3321a, differentiated adjustment of the light transmittance of the light-transmissive aperture 100 can be achieved. Generally, the first dummy auxiliary line 3321 extending in the third direction X3 is the first signal line 310, and the first break 310a is formed in the first dummy auxiliary line 3321. Lines on both sides of the first break 310a are first dummy auxiliary sub-lines 3321a. The first break 310a can effectively avoid blocking of light, thereby increasing the light transmittance of the light-transmissive aperture 100 and enhancing the light transmittance of the display panel 10.

With continued reference to FIG. 12, the first data signal line 321 is located on the side of the first dummy auxiliary sub-line 3321a facing the light-transmissive aperture 100, and the first data signal line 321 includes a first main portion 3211 and a first bent portion 3212 electrically connected to each other. In the fourth direction X4, the orthographic projection of the first bent portion 3212 on the substrate 200 overlaps the orthographic projection of the light-transmissive aperture 100 on the substrate 200. In the third direction X3, the orthographic projection of the first bent portion 3212 on the substrate 200 overlaps the orthographic projection of the first dummy auxiliary sub-line 3321a on the substrate 200.

In embodiments, as shown in FIG. 12, the first data signal line 321 includes the first main portion 3211 and the first bent portion 3212. The first main portion 3211 can be understood as the main line structure extending in the third direction X3, while the first bent portion 3212 (see region C1 of FIG. 12) can be understood as a line structure that protrudes relative to the first main portion 3211 in the first data signal line 321 or a line structure bent relative to the first main portion 3211. That is, the extension direction of at least part of the first bent portion 3212 intersects the extension direction of the first main portion 3211.

In embodiments, in the fourth direction X4, the orthographic projection of the first bent portion 3212 on the substrate 200 overlaps the orthographic projection of the light-transmissive aperture 100 on the substrate 200. That is, when the orthographic projection of the first bent portion 3212 on the substrate 200 and the orthographic projection of the light-transmissive aperture 100 on the substrate 200 are compared, the two projections overlap with each other in the fourth direction X4. Alternatively, this can be understood as that, as shown in FIG. 12, in a plan view (top view) ignoring the positional relationship between layers accommodating the first bent portion 3212 and the light-transmissive aperture 100, the first bent portion 3212 and the light-transmissive aperture 100 overlap with each other in the fourth direction X4.

In embodiments, as shown in FIG. 12, the first data signal line 321 is located on the side of the first dummy auxiliary sub-line 3321a facing the light-transmissive aperture 100. In conjunction with the positional relationship between the first bent portion 3212 and the light-transmissive aperture 100, it can be seen that light transmitted to the light-transmissive aperture 100 is blocked at the position where the first data signal line 321 is located, thereby affecting the light transmittance of the light-transmissive aperture 100, that is, affecting the light transmittance of the display panel 10. In conjunction with the first break 310a in the first signal line 310, the first data signal line 321 is adjusted to increase the light transmittance of the light-transmissive aperture 100, thus enhancing the light transmittance of the display panel 10.

By way of example, in the third direction X3, the orthographic projection of the first bent portion 3212 on the substrate 200 overlaps the orthographic projection of the first dummy auxiliary sub-line 3321a on the substrate 200. That is, when the orthographic projection of the first bent portion 3212 on the substrate 200 and the orthographic projection of the first dummy auxiliary sub-line 3321a on the substrate 200 are compared, the two projections overlap with each other in the third direction X3. Alternatively, this can be understood as that, as shown in FIG. 12, the first bent portion 3212 extends to the first break 310a of the first signal line 310. Therefore, in the third direction X3, the orthographic projection of the first bent portion 3212 on the substrate 200 overlaps the orthographic projection of the first dummy auxiliary sub-line 3321a on the substrate 200. That is, in a plan view (top view) ignoring the positional relationship between layers accommodating the first bent portion 3212 and the first signal line 310, the first bent portion 3212 extends to the first break 310a, and the two projections at least partially overlap with each other in the third direction X3.

In embodiments, in the comparison between FIG. 8 and FIG. 12, the first signal line 310 has a first break 310a, and part of the first data signal line 321 at one side of the first signal line 310 facing the light-transmissive aperture 100 extends to the first break 310a, further preventing the first data signal line 321 from blocking the light, effectively increasing the light transmittance of the light-transmissive aperture 100, and improving the overall light transmittance of the display panel 10.

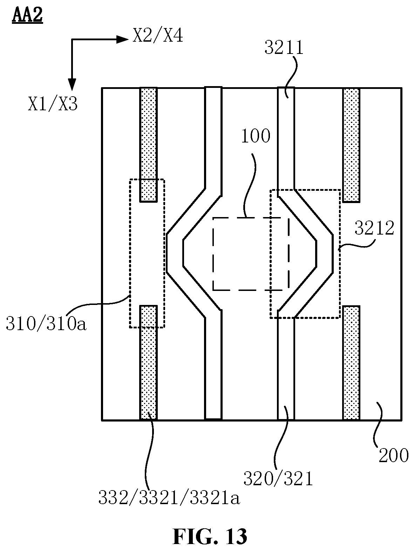

FIG. 13 is a fifth enlarged view of an auxiliary display region according to embodiments of this application. As shown in FIG. 9 and FIG. 13, the first data signal line 321 is located on the side of the first dummy auxiliary sub-line 3321a facing the light-transmissive aperture 100, and the first data signal line 321 includes a first main portion 3211 and a first bent portion 3212 electrically connected to each other. In the fourth direction X4, the orthographic projection of the first bent portion 3212 on the substrate 200 overlaps the orthographic projection of the light-transmissive aperture 100 on the substrate 200. In the third direction X3, the orthographic projection of the first bent portion 3212 on the substrate 200 is non-overlapping with the orthographic projection of the first dummy auxiliary sub-line 3321a on the substrate 200.

In embodiments, as shown in FIG. 13, in the third direction X3, the orthographic projection of the first bent portion 3212 on the substrate 200 overlaps the orthographic projection of the first dummy auxiliary sub-line 3321a on the substrate 200. That is, when the orthographic projection of the first bent portion 3212 on the substrate 200 and the orthographic projection of the first dummy auxiliary sub-line 3321a on the substrate 200 are compared, the two projections are non-overlapping with each other in the third direction X3. That is, in a plan view (top view) ignoring the positional relationship between layers accommodating the first bent portion 3212 and the first dummy auxiliary sub-line 3321a, the two projections are non-overlapping with each other in the third direction X3. Alternatively, this can be understood as that, as shown in FIG. 13, the first bent portion 3212 does not extend or expand towards the first break 310a of the first signal line 310, or the first bent portion 3212 extends and expands towards the first break 310a of the first signal line 310, but the first bent portion 3212 does not extend into the region where the first break 310a is located. Therefore, in the third direction X3, the orthographic projection of the first bent portion 3212 on the substrate 200 is non-overlapping with the orthographic projection of the first dummy auxiliary sub-line 3321a on the substrate 200.

In embodiments, as shown in FIG. 13, when the first signal line 310 has the first break 310a, the first data signal line 321 is not significantly adjusted, thereby reducing the difficulty in manufacturing the first data signal line 321. In embodiments, although there is a first bent portion 3212 between the first break 310a and the light-transmissive aperture 100, the light transmittance of the display panel 10 can be effectively improved, as the first signal line 310 is broken and is closer to the light-transmissive aperture 100 than other lines.

As shown in FIG. 9 and FIG. 11, the first data signal line 321 is located on the side of the first dummy auxiliary sub-line 3321a facing away from the light-transmissive aperture 100, and in the thickness direction of the display panel 10, the first break 310a overlaps the light-transmissive aperture 100.

As shown in FIG. 11, the first data signal line 321 is located on the side of the first dummy auxiliary sub-line 3321a facing away from the light-transmissive aperture 100, that is, the first signal line 310 is located on the side of the first data signal line 321 facing the light-transmissive aperture 100.

In embodiments, as shown in FIG. 11, the first signal line 310 has the first break 310a, and in the thickness direction of the display panel 10, the first break 310a and the light-transmissive aperture 100 overlap with each other when projected on the substrate 200. This can be understood as that the first signal line 310 is closer to the light-transmissive aperture 100 than other signal lines 300. In the fourth direction X4, the part of the line corresponding to the light-transmissive aperture 100 is broken, that is, provided with a first break 310a. The first break 310a directly prevents the line from blocking the light, directly increasing the light transmittance of the light-transmissive aperture 100 and improving the overall light transmittance of the display panel 10.

In embodiments, in the comparison between FIG. 7 and FIG. 11, in FIG. 7, the region with no break blocks the light-transmissive aperture 100, thereby affecting the light transmittance of the light-transmissive aperture 100; whereas in FIG. 11, the first signal line 310 is broken, that is, the first break 310a is provided with the first break 310a that does not block light. By providing the first signal line 310 with the first break 310a, the light transmittance of the light-transmissive aperture 100 is directly increased and the overall light transmittance of the display panel 10 is improved.

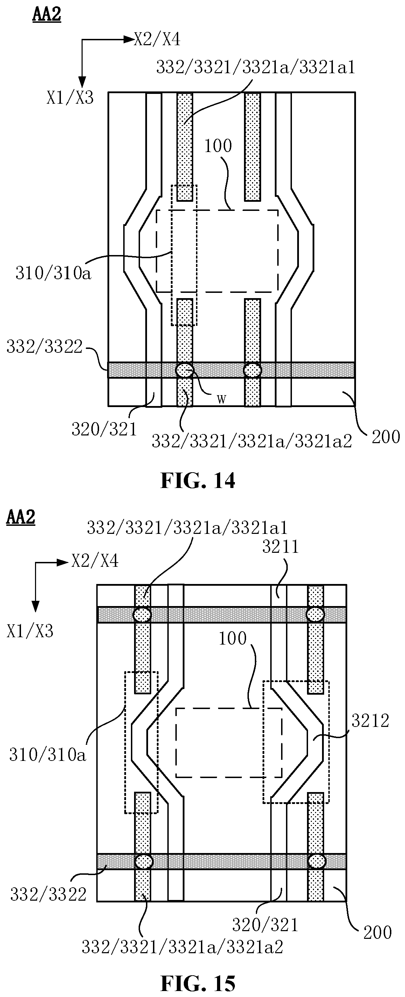

FIG. 14 is a sixth enlarged view of an auxiliary display region according to embodiments of this application. FIG. 15 is a seventh enlarged view of an auxiliary display region according to embodiments of this application. As shown in FIG. 9, FIG. 14, and FIG. 15, the first dummy auxiliary sub-line 3321a includes a first line segment 3321a1 and a second line segment 3321a2 respectively on both sides of the first break 310a. Multiple first line segments 3321a1 arranged in the fourth direction X4 are electrically connected to each other through the second dummy auxiliary line 3322; and/or multiple second line segments 3321a2 arranged in the fourth direction X4 are electrically connected to each other through the second dummy auxiliary line 3322.

Referring to FIG. 9, the dummy auxiliary line 332 includes a first dummy auxiliary line 3321 and a second dummy auxiliary line 3322 electrically connected to each other. The extension direction of the first dummy auxiliary line 3321 and the extension direction of the second dummy auxiliary line 3322 are different from each other. As shown in FIG. 14 and FIG. 15, the first dummy auxiliary line 3321 may be the first signal line 310, and the first dummy auxiliary line 3321 includes the first dummy auxiliary sub-line 3321a. The first dummy auxiliary sub-line 3321a includes a first line segment 3321a1 and a second line segment 3321a2 respectively located on both sides of the first break 310a. In embodiments, potential signals provided to the first line segment 3321a1 and the second line segment 3321a2 are adjusted, thus enabling the dummy auxiliary line 332 to transmit the relevant potential signals.

By way of example, as shown in FIG. 14, multiple first line segments 3321a1 arranged in the fourth direction X4 may be electrically connected to each other through the second dummy auxiliary lines 3322, that is, when the dummy auxiliary lines 332 transmit electrical signals, electrical connection between the first line segments 3321a1 can be achieved through the second dummy auxiliary line 3322 (that is, electrical connection through vias as shown in regions w in FIG. 14). In embodiments, when multiple first line segments 3321a1 arranged in the fourth direction X4 are electrically connected to each other through the second dummy auxiliary line 3322, multiple second line segments 3321a2 arranged in the fourth direction X4 may be directly electrically connected to a signal bus that transmits potential signals, to acquire the relevant potential signals. Alternatively, as shown in FIG. 15, multiple second line segments 3321a2 arranged in the fourth direction X4 may also be electrically connected to each other through the second dummy auxiliary line 3322, that is, when the dummy auxiliary lines 332 transmit electrical signals, electrical connection between the second line segments 3321a2 can be achieved through the second dummy auxiliary line 3322. It is noted that FIG. 14 illustrates an example in which the first dummy auxiliary sub-line 3321a is located on the side of the first data signal line 321 facing away from the light-transmissive aperture 100; while FIG. 15 illustrates an example in which the first dummy auxiliary sub-line 3321a is located on the side of the first data signal line 321 facing the light-transmissive aperture 100.

Similarly, multiple second line segments 3321a2 arranged in the fourth direction X4 are electrically connected to each other through the second dummy line 3322, and multiple first line segments 3321a1 arranged in the fourth direction X4 may be directly electrically connected to a signal bus that transmits potential signals, to acquire the relevant potential signals. Alternatively, as shown in FIG. 15, multiple second line segments 3321a2 arranged in the fourth direction X4 can also be electrically connected to each other through the second dummy auxiliary line 3322, that is, when the dummy auxiliary lines 332 transmit the electrical signals, electrical connection between the second line segments 3321a2 can be achieved through the second dummy auxiliary line 3322.

In other words, the first dummy auxiliary line 3321 may have a break (a first break 310a) at the auxiliary display region AA2. In this case, the first dummy auxiliary line 3321 can still receive the relevant electrical signals by being electrically connected to the second dummy auxiliary line 3322, thus ensuring that the first dummy auxiliary line 3321 with the break can still receive relevant electrical signals. In this case, the second dummy auxiliary line 3322 extending in the fourth direction X4 is required to be implement direct electrical connection between the first dummy auxiliary lines 3321. Therefore, the second dummy auxiliary line 3322 partially disposed in the auxiliary display region AA2 is configured as a continuous line with no break in the fourth direction X4.

Generally, the electrical connections for the first line segments 3321a1 and the second line segments 3321a2 can be implemented in various manners, which is not limited in embodiments of this application.

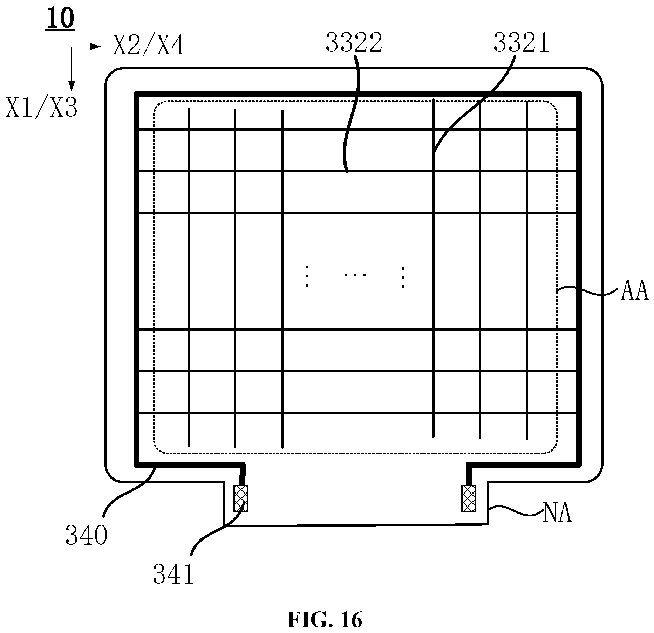

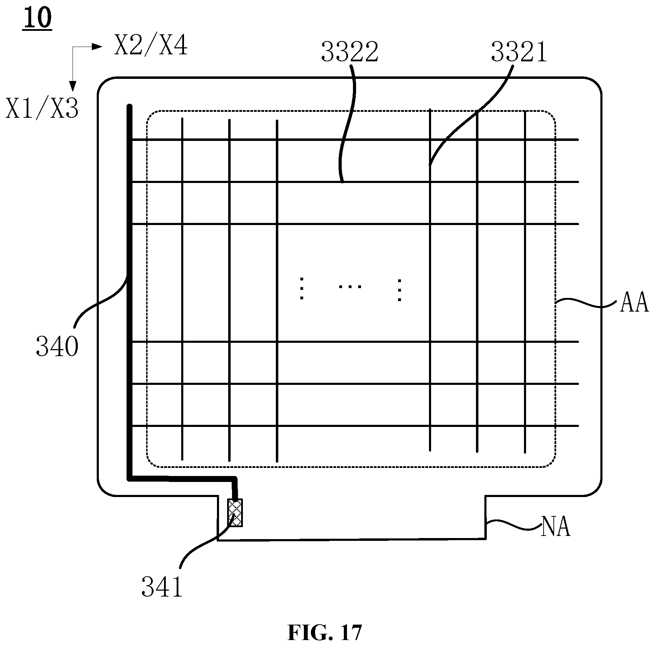

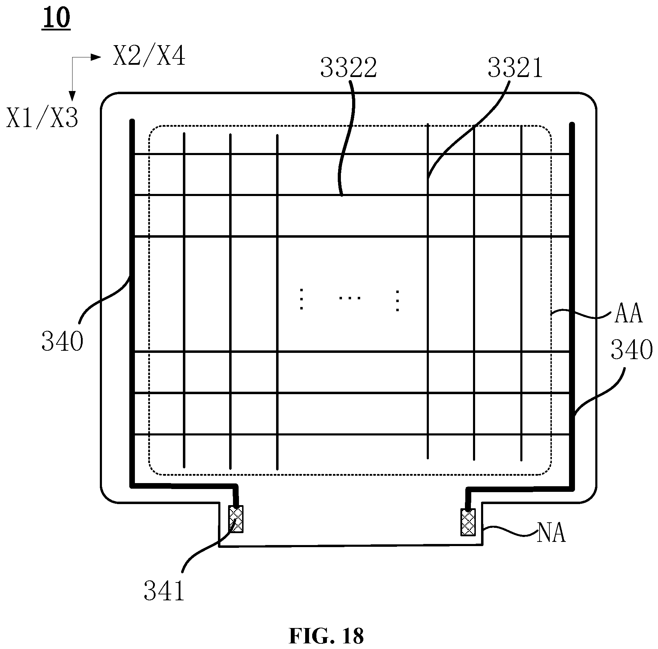

FIG. 16 is a third diagram illustrating the structure of a display panel according to embodiments of this application. FIG. 17 is a fourth diagram illustrating the structure of a display panel according to embodiments of this application. FIG. 18 is a fifth diagram illustrating the structure of a display panel according to embodiments of this application. As shown in FIG. 9 and FIG. 16 to FIG. 18, the display panel 10 also includes a signal bus 340 located in the non-display region NA, the second dummy auxiliary line 3322 is electrically connected to the signal bus 340, and the signal bus 340 is located on at least one side of the display region AA in the fourth direction X4.

As shown in FIG. 16 to FIG. 18, the display panel 10 also includes a signal bus 340 located in the non-display region NA of the display panel 10. The electrical signals transmitted through the signal bus 340 are electrically connected to a subset of the signal lines 300 located in the display region AA. In embodiments, as shown in FIG. 16 to FIG. 18, the signal bus 340 is electrically connected to a metal pad 341 in the non-display region NA. By way of example, the signal bus 340 can be configured to transmit power signals, such as negative power supply signals (PVEE). The type of signals transmitted by the signal bus 340 is not limited in embodiments of this application.

As shown in FIG. 16 to FIG. 18, the second auxiliary dummy line 3322 may be electrically connected to the signal bus 340, that is, the dummy auxiliary line 332 is configured to transmit the electrical signals provided by the signal bus 340. For the first dummy auxiliary sub-line 3321a (that is, the first dummy virtual line 3321 partially located in the auxiliary display region AA2), due to the presence of the first break 310a, to ensure that the first dummy auxiliary sub-line 3321a can receive the relevant electrical signals, the first dummy auxiliary line 3321a is configured to acquire and transmit the electrical signals by being electrically connected to the second auxiliary dummy line 3322.

In embodiments, the signal bus 340 is flexibly disposed in the non-display region NA. As shown in FIG. 16, the signal bus 340 surrounds the display region AA, that is, the signal bus 340 encircles the display region AA. Alternatively, as shown in FIG. 17, in the fourth direction X4, the signal bus 340 is located on one side of the display region AA. Alternatively, as shown in FIG. 18, in the fourth direction X4, the signal bus 340 is located on both sides of the display region AA. The position of the signal bus 340 in the non-display region NA is flexible and varies depending on the different requirements of the display panel 10 or the differentiated configuration of the non-display region NA in the display panel 10, which is not limited in embodiments of this application.

In embodiments, the second auxiliary dummy line 3322 electrically connected to the signal bus 340 extends in the fourth direction. Therefore, the signal bus 340 is located on at least one side of the display region AA in the fourth direction X4. This ensures that the electrical connection between the second dummy auxiliary line 3322 and the signal bus 340 is simple. Thus, the electrical signals transmitted by the signal bus 340 can be directly transmitted to the dummy auxiliary line 332 over a shorter distance, thereby ensuring the stability and reliability of the transmission of the electrical signals. This can improve the overall performance of the display panel 10.

In embodiments, the second dummy auxiliary line 3322 is configured to receive a fixed-potential signal.

By way of example, the second dummy auxiliary line 3322 is electrically connected to the signal bus 320. In embodiments, the second dummy auxiliary line 3322 receives the fixed-potential signal transmitted by the signal bus 320. The second dummy auxiliary line 3322 is electrically connected to the first dummy auxiliary line 3321, that is, the dummy auxiliary line 332 is configured to receive and transmit the fixed-potential signal.

In embodiments, on one hand, this can prevent interference to the display panel 10 caused by the dummy auxiliary line 332 coupling, due to the floating potential thereof, with other signals; and on the other hand, the dummy auxiliary line 332 is connected in parallel with the fixed-potential signal line, thereby reducing the resistance on the fixed-potential signal line and ensuring minimal loss during the transmission of the fixed-potential signals.

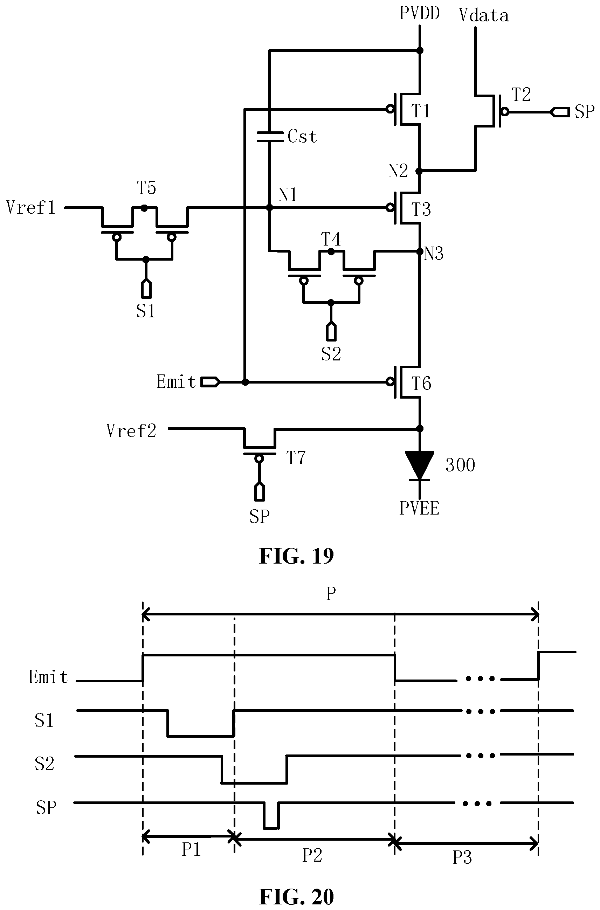

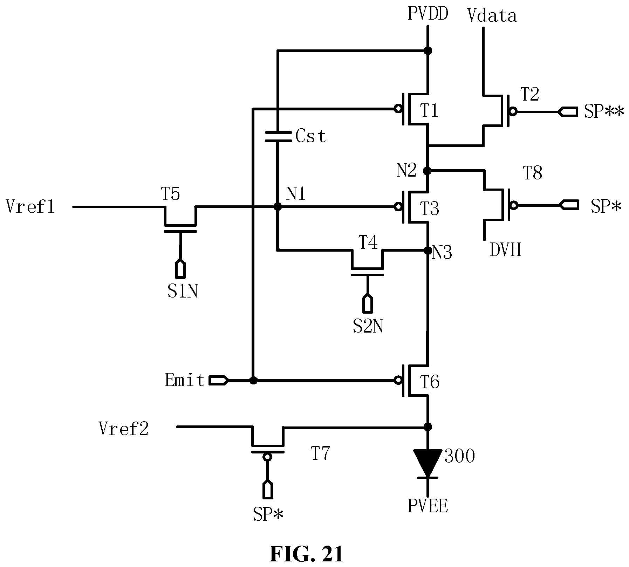

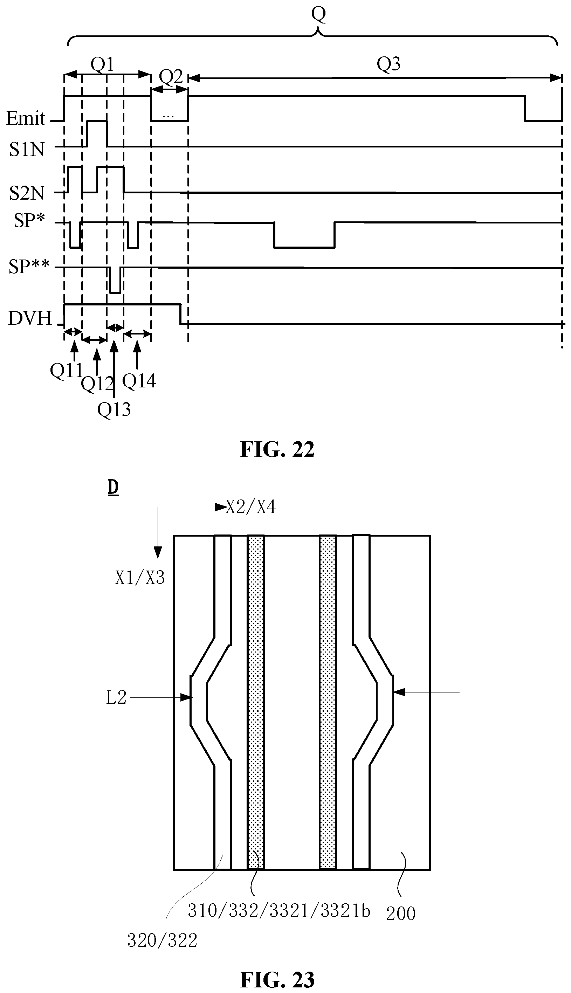

FIG. 19 is a first diagram illustrating the structure of a pixel circuit according to embodiments of this application. FIG. 20 is a timing diagram of signals provided for the pixel circuit of FIG. 19 in one drive cycle according to embodiments of this application. FIG. 21 is a second diagram illustrating the structure of a pixel circuit according to embodiments of this application. FIG. 22 is a timing diagram of signals provided for the pixel circuit of FIG. 21 in one drive cycle according to embodiments of this application. As shown in FIG. 1 and FIG. 19 to FIG. 22, the fixed-potential signal includes a power signal, an initialization signal, or a bias adjustment signal.

The display panel 10 also includes multiple pixel circuits in the display region AA. The pixel circuits are electrically connected to the light-emitting elements 400, enabling the driving of the light-emitting elements 400 to ensure light emission and display of the light-emitting elements 400. In embodiments, the signal lines 200 in the display panel 10 are configured to provide voltage signals and/or current signals to the pixel circuits so that the pixel circuits drive the light-emitting elements 400.

The pixel circuit may be configured in various manners, which in turn leads to a diversity in the configuration of the display panel 10.. By way of example, FIG. 19 illustrates an example in which the pixel circuit 100 is a pixel circuit of 7T1C. The configuration of the pixel circuit can be adapted by those skilled in the art according to the requirements. The pixel circuit may include a first light emission control transistor T1, a data write transistor T2, a drive transistor T3, a threshold compensation transistor T4, an initialization reset transistor T5, a second light emission control transistor T6, an anode reset transistor T7, and a storage capacitor Cst. In embodiments, the types of the transistors in the pixel circuit may be diverse. The transistors may include low-temperature polysilicon (Low Temperature Poly-Silicon, LTPS) transistors having advantages such as high switching speed, high carrier mobility, and low power consumption.

The timing sequence of an operation process of the pixel circuit 100 is illustrated with reference to FIG. 20. The scan signal line (indicated by S1 in the figure) connected to a control terminal of the initialization reset transistor T5 may control the initialization reset transistor T5 to turn on and off. When the initialization reset transistor T5 is turned on, a reset signal in an initialization reset signal line (indicated by Vref1 in the figure) connected to an input terminal of the initialization reset transistor T5 is written to a gate of the drive transistor T3 (that is, the initialization signal includes a gate initialization signal), to reset a first node N1. The storage capacitor Cst can ensure that the potential of the first node N1 is stable. A scan signal line (indicated by SP in the figure) connected to a control terminal of the data write transistor T2 may control the data write transistor T2 to turn on and off. When the data write transistor T2 is turned on, a data signal in a data signal line (indicated by Vdata in the figure) is written to a first electrode of the drive transistor T3. A scan signal line (indicated by S2 in the figure) connected to a control terminal of the threshold compensation transistor T4 may control the threshold compensation transistor T4 to turn on and off. When the threshold compensation transistor T4 is turned on, a threshold voltage is compensated to the drive transistor T3. Moreover, a scan signal line (indicated by SP in the figure) connected to a control terminal of the anode reset transistor T7 may control the anode reset transistor T7 to turn on and off. When the anode reset transistor T7 is turned on, the anode of the light-emitting element 400 connected to the pixel circuit is reset, that is, an initialization signal in an anode initialization signal line (indicated by Vref2 in the figure) is written to the anode of the light-emitting element 400. That is, the initialization signal includes an anode initialization signal. A light emission control signal line (indicated by Emit in the figure) connected to a control terminal of the first light emission control transistor T1 and a control terminal of the second light emission control transistor T6 may control the first light emission control transistor T1 and the second light emission control transistor T6 to turn on and off. When the first light emission control transistor T1 and the second light emission control transistor T6 are turned on, a power signal transmitted by a positive power supply signal line PVDD is written to the anode of the light-emitting element 400, and the cathode of the light-emitting element 400 is connected to a negative power supply signal line PVEE, thereby enabling the display and light emission of the light-emitting element 400. By way of example, as shown in FIG. 20, the duration of one frame of the display panel 10 includes at least an initialization write stage P1, a data write stage P2, and a light emission stage P3. In the initialization stage P1, the initialization reset transistor T5 is turned on under the control of the scan signal line (indicated by S1 in the figure), the initialization signal in the initialization signal line (indicated by Vref1 in the figure) is written to the first node N1 electrically connected to the gate of the drive transistor T3, to initialize the gate of the drive transistor T3. Moreover, since the threshold compensation transistor T4 is turned on, the initialization signal in the gate initialization signal line (indicated by Vref1 in the figure) is written to a second electrode of the drive transistor T3, that is, a node N3. In the data write stage P2, the data write transistor T2 is turned on under the control of the scan signal line (indicated by SP in the figure), and the threshold compensation transistor T4 is turned on under the control of the scan signal line (indicated by S2 in the figure) so that the data signal Vdata is written to the gate of the drive transistor T3 after passing through the data write transistor T2, the drive transistor T3, and the threshold compensation transistor T4 in sequence. Moreover, in the data write stage P2, the anode reset transistor T7 is turned on under the control of the scan signal line (indicated by SP in the figure), and the initialization signal in the anode initialization signal line (indicated by Vref2 in the figure) is written to the anode of the light-emitting element 400, to initialize the anode of the light-emitting element 400. In the light emission stage T3, the first light emission transistor T1 and the second light emission control transistor T6 are turned on under the control of a light emission control signal Emit, so that a drive current generated by the drive transistor T3 can be transmitted to the anode of the light-emitting element 400, thereby driving the light-emitting element 400 to emit light.

In embodiments, as shown in FIG. 19, the fixed-potential signals supplied to the pixel circuit may include the power supply signal and the initialization signal. The power supply signal includes the positive power supply signal (PVDD) and the negative power supply signal (PVEE). The initialization signal includes the gate initialization signal and the anode initialization signal. Therefore, the fixed-potential signal received by the second dummy auxiliary line 3322 may be the power supply signal and/or the initialization signal.

In embodiments, FIG. 21 and FIG. 22 illustrate an example in which the pixel circuit is a pixel circuit of 8T1C. The pixel circuit may include a first light emission control transistor T1, a data writing transistor T2, a drive transistor T3, a threshold compensation transistor T4, an initialization reset transistor T5, a second light emission control transistor T6, an anode reset transistor T7, a bias transistor T8, and a storage capacitor Cst. In embodiments, the pixel circuit shown in FIG. 17 includes a low-temperature polycrystalline silicon transistor and an indium gallium zinc oxide (Indium Gallium Zinc Oxide, IGZO) transistor. The indium gallium zinc oxide transistor has the advantages such as small leakage current. The low-temperature polycrystalline silicon transistor has the advantages such as high switching speed, high carrier mobility, and low power consumption.

The operation process of the pixel circuit is similar to the operation process of the pixel circuit corresponding to FIG. 19 and thus is not repeated here. In embodiments, in the pixel circuit of FIG. 21, a scan signal line (indicated by SP* in the figure) connected to a control terminal of the bias transistor T8 may control the bias transistor T8 to turn on and off. When the bias transistor T8 is turned on, a bias adjustment signal transmitted by a bias adjustment signal line (indicated by DVH in the figure) is written to the bias transistor T8, to perform bias adjustment on a second node N2.

By way of example, reference can be made to in FIG. 22 for the timing sequence of an operation process of the pixel circuit. In embodiments, one drive cycle Q of the pixel circuit includes a data write stage Q1, a light emission stage Q2, and a light emission retention stage Q3. The data write stage Q1 includes a non-enabling-level stage of a light emission control signal Emit, the light emission stage Q2 includes an enabling-level stage of the light emission control signal Emit, and in the light emission retention stage Q3, the light emission control signal Emit includes multiple non-enabling-level stages and at least one enabling-level stage (FIG. 22 illustrates one enabling-level stage by way of example). Moreover, the level of a bias adjustment signal in the bias adjustment signal line (indicated by DVH in the figure) in the data write stage Q1 and the light emission stage Q2 may be the same as the level of the bias adjustment signal in the bias adjustment signal line (indicated by DVH in the figure) in the light emission retention stage Q3. In embodiments, the data write stage Q1 includes a first bias adjustment stage Q11. In the first bias adjustment stage Q11, a signal transmitted by the scan signal line (indicated by SP* in the figure) includes at least one low-level period, and within this period, a signal transmitted by a scan signal line (indicated by S2N in the figure) includes at least one high-level period. In other words, at least the bias transistor T8 and the threshold compensation transistor T4 are turned on in the first bias adjustment stage Q11, and the bias adjustment signal in the bias adjustment signal line (indicated by DVH in the figure) is transmitted to the drive transistor T3 through the bias transistor T8, and transmitted to the gate of the drive transistor T3 through the threshold compensation transistor T4. That is, in the first bias adjustment stage Q11, the bias signal can perform bias adjustment on the first node N1, the second node N2, and the third node N3. The data write stage Q1 also includes an initialization and second bias adjustment stage Q12. In the initialization and second bias adjustment stage Q12, the signal transmitted by the scan signal line (indicated by S2N in the figure) includes at least one high-level period. Moreover, the signal transmitted by the scan signal line (indicated by S2N in the figure) includes at least one high-level period. In other words, during the initialization and second bias adjustment stage Q12, the initialization transistor T5 is turned on, and subsequently, the threshold compensation transistor T4 is also turned on. A gate initialization reset signal in an initialization signal line (indicated by Vref1 in the figure) may adjust the gate of the drive transistor T3 through the initialization transistor T5 and may also adjust the third node N3 through the initialization transistor T5 and the threshold compensation transistor T4. The data write stage Q1 also includes a data signal write stage Q13. In the data signal write stage Q13, the signal transmitted by the scan signal line (indicated by S2N in the figure) includes a high-level period, and a signal transmitted by a scan signal line (indicated by SP** in the figure) includes at least one low-level period. In other words, during the data signal write stage Q13, the data write transistor T2 and the threshold compensation transistor T4 are turned on, and the data signal in the data signal line (indicated by Vdata in the figure) can be transmitted to the gate of the drive transistor T3 through the data write transistor T2 and the threshold compensation transistor T4. The data write stage Q1 also includes a third bias adjustment stage Q14. In the third bias adjustment stage Q14, the signal transmitted by the scan signal line (indicated by SP* in the figure) includes at least one low-level period. Within this period, bias adjustment can be performed on the second node N2 again through the bias transistor T8.

In embodiments, as shown in FIG. 21, the fixed-potential signal supplied to the pixel circuit may include the power supply signal, the initialization signal, and the bias adjustment signal. The power supply signal includes the positive power supply signal (PVDD) and the negative power supply signal (PVEE). The initialization signal includes the gate initialization reset signal and the anode reset signal. Therefore, the fixed-potential signal received by the second dummy auxiliary line 3322 may be at least one of the power supply signal, the initialization signal, or the bias adjustment signal.

The type of the fixed-potential signal received by the second dummy auxiliary line 3322 is diverse and can be adapted to different display panels 10, which is not described in detail in embodiments of this application.

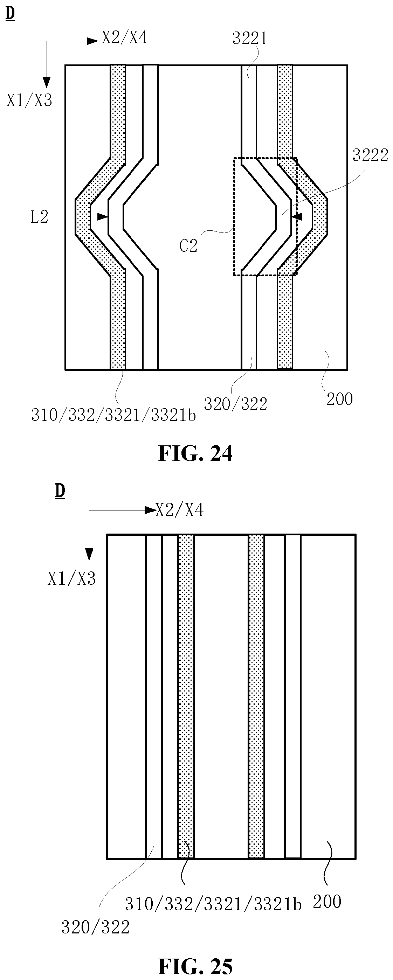

FIG. 23 is a first enlarged view of region D of FIG. 1. FIG. 24 is a second enlarged view of region D of FIG. 1. FIG. 25 is a third enlarged view of region D of FIG. 1. As shown in FIG. 23 to FIG. 25, the data signal lines 320 include a second data signal line 322 located in the main display region AA1. The second data signal line 322 includes a second main portion 3221 and a second bent portion 3222 electrically connected to each other.

FIG. 23 and FIG. 24 are each an enlarged view of region D of FIG. 1, that is, an enlarged view of the display panel 10 in the main display region AA1. By way of example, the data signal lines 320 include a first data signal line 321 and a second data signal line 322. The first data signal line 321 is at least partially located in the auxiliary display region AA2. The second data signal line 322 is located in the main display region AA1.

In embodiments, as shown in FIG. 24, the second data signal line 322 includes a second main portion 3221 and a second bent portion 3222 electrically connected to each other. As shown in FIG. 12, FIG. 13, and FIG. 24, the first data signal line 321 includes a first main portion 3211 and a first bent portion 3212. That is, the data signal lines 320 are arranged in the same manner: The first data signal line 321 and the second data signal line 322 each include a main portion and a bent portion, which can reduce the difficulty in manufacturing the data signal lines 320. In embodiments, as shown in FIG. 11 and FIG. 23, the first data signal lines 321 and the second data signal lines 322 are arranged in the same manner.

In embodiments, as shown in FIG. 25, the second data signal lines 322 located in the main display region AA1 may alternatively have no second bent portion 3222, thereby reducing the space occupied by the data signal lines 320 in the main display region AA1 and providing more space for other lines.

In embodiments, as shown in FIG. 11, FIG. 12, FIG. 23, and FIG. 24, the data signal lines 320 include the first data signal line 321, and at least part of the first data signal line 321 is located in the auxiliary display region AA2. The first data signal line 321 includes a first main portion 3211 and a first bent portion 3212 electrically connected to each other, and in the fourth direction X4, the orthographic projection of the first bent portion 3212 on the substrate 200 overlaps the orthographic projection of the light-transmissive aperture 100 on the substrate 200. Two adjacent first data signal lines 321 include two adjacent first bent portions 3212, respectively, and the distance between the two adjacent first bent portions 3212 is L1; and two adjacent second data signal lines 320 include two adjacent second bent portions 3222, respectively, and the distance between the two adjacent second bent portions 3222 is L2, where L1 ≥ L2.

By way of example, as shown in FIG. 11, two adjacent first data signal lines 321 include two adjacent first bent portions 3212, respectively, and in the fourth direction X4, the distance between the two adjacent first bent portions 3212 is L1. In embodiments, as shown in FIG. 23, two adjacent second data signal lines 322 include two adjacent second bent portions 3222, respectively, and in the fourth direction X4, the distance between the two adjacent second bent portions 3222 is L2, where L1 ≥ L2. This can be understood as that the second bent portions 3222 in the second data signal lines 322 located in the main display region AA1 and the first bent portions 3212 in the first data signal lines 321 located in the auxiliary display region AA2 are arranged in the same or similar manner. That is, wiring of the data signal lines 320 in the main display region AA1 and wiring of the data signal lines 320 in the auxiliary display region AA2 are uniform, ensuring the uniform display of the display panel 10.

Similarly, as shown in FIG. 12, two adjacent first data signal lines 321 include two adjacent first bent portions 3212, respectively, and in the fourth direction X4, the distance between the two adjacent first bent portions 3212 is L1. In embodiments, as shown in FIG. 24, two adjacent second data signal lines 322 include two adjacent second bent portions 3222, respectively, and in the fourth direction X4, the distance between the two adjacent second bent portions 3222 is L2, where L1 ≥ L2. This can be understood as that the second bent portions 3222 in the second data signal lines 322 located in the main display region AA1 and the first bent portions 3212 in the first data signal lines 321 located in the auxiliary display region AA2 are arranged in the same or similar manner.

With continued reference to FIG. 23 to FIG. 25, the first dummy auxiliary line 3321 includes a second dummy auxiliary sub-line 3321b located in the main display region AA1. The second dummy auxiliary sub-line 3321b is adjacent to the second data signal line 320.

In embodiments, as shown in FIG. 23, the first dummy auxiliary line 3321 include the first dummy auxiliary sub-line 3321a and the second dummy auxiliary sub-line 3321b. The first dummy auxiliary sub-line 3321a is at least partially located in the auxiliary display region AA2. The second dummy auxiliary sub-line 3321b is located in the main display region AA1. Similarly, as shown in FIG. 24 and FIG. 25, in the auxiliary display region AA2, the first dummy auxiliary line 3321 include the second dummy auxiliary sub-line 3321b.

In embodiments, in the auxiliary display region AA2, a subset of the first dummy auxiliary sub-lines 3321a are adjacent to the first data signal lines 321; and in the main display region AA1, the second dummy auxiliary sub-line 3321b is adjacent to the second data signal line 320. In other words, the main display region AA1 also contains dummy auxiliary lines 332; and in the auxiliary display region AA2, the dummy auxiliary lines 332 are adjacent to the data signal lines 320, and in the main display region AA1, the dummy auxiliary lines 332 are adjacent to the data signal lines 320. The signal lines 300 in the main display region AA1 and the signal lines 300 in the auxiliary display region AA2 are arranged in a similar manner.

As shown in FIG. 23 and FIG. 24, in the fourth direction X4, the orthographic projection of the second dummy auxiliary sub-line 3321b on the substrate 200 overlaps the orthographic projection of the second bent portion 3222 on the substrate 200.

In embodiments, in the fourth direction X4, the orthographic projection of the second dummy auxiliary sub-line 3321b on the substrate 200 overlaps the orthographic projection of the second bent portion 3222 on the substrate 200. That is, when the orthographic projection of the second dummy auxiliary sub-line 3321b on the substrate 200 and the orthographic projection of the second bent portion 3222 on the substrate 200 are compared, the two projections overlap with each other in the fourth direction X4. Alternatively, this can be understood as that, as shown in FIG. 23 and FIG. 24, in a plan view (top view) ignoring the positional relationship between layers accommodating the second dummy auxiliary sub-line 3321b and the second bent portion 3222, the second bent portion 3222 overlaps the second dummy auxiliary sub-line 3321b in the fourth direction X4. That is, the first dummy auxiliary sub-line 3321a and the second dummy auxiliary sub-line 3321b are different in that the first dummy auxiliary sub-line 3321a has a first break 310a while the second dummy auxiliary sub-line 3321b is a complete line without break. This ensures that in the fourth direction X4, the orthographic projection of the second dummy auxiliary sub-line 3321b on the substrate 200 overlaps the orthographic projection of the second bent portion 3222 on the substrate 200.

In embodiments, the second dummy auxiliary sub-line 3321b located in the main display region AA1 is not broken, thereby ensuring the continuity of signal transmission in the second dummy auxiliary sub-line 3321b and ensuring the signal transmission effect of the display panel 10.

In embodiments, in the comparison between FIG. 23 and FIG. 11 or between FIG. 24 and FIG. 12, to improve the transmittance of the auxiliary display region AA2, that is, to improve the light transmittance of the light-transmissive aperture 100, the second dummy auxiliary sub-line 3321a is broken by providing the first break 310a. In contrast, as the light transmittance of the main display region AA1 of the display panel 10 is not a concern, the second dummy auxiliary sub-line 3321b has no break. When the dummy auxiliary line 332 transmits the potential signals, this arrangement can reduce the process of crossing and connecting through vias, thereby reducing the manufacturing cost of the display panel 10.

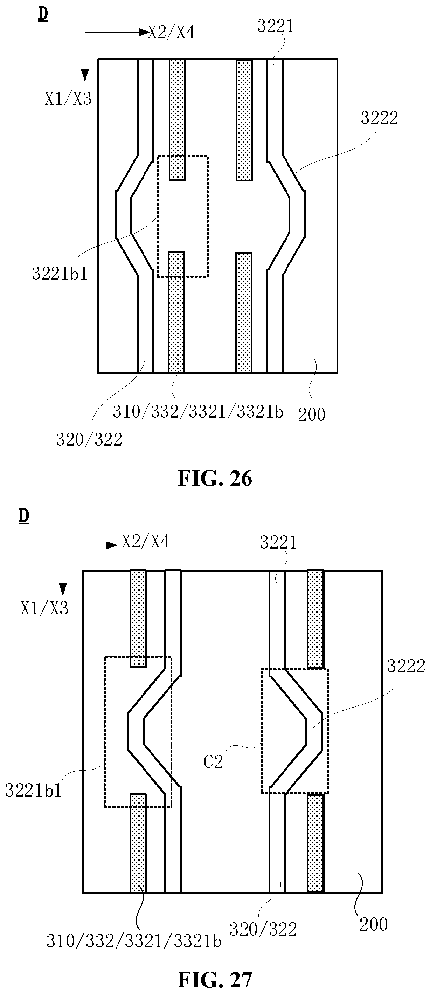

FIG. 26 is a fourth enlarged view of region D of FIG. 1. FIG. 27 is a fifth enlarged view of region D of FIG. 1. As shown in FIG. 26 and FIG. 27, the second dummy auxiliary sub-line 3321b has a second break 3321b1. In the fourth direction, the orthographic projection of the second break 3321b1 on the substrate 200 overlaps the orthographic projection of the second bent portion 3222 on the substrate 200.

In embodiments, as shown in FIG. 26 and FIG. 27, the second dummy auxiliary sub-line 3321b has the second break 3321b1. In the fourth direction X4, the orthographic projection of the second break 3321b1 on the substrate 200 overlaps the orthographic projection of the second bent portion 3222 on the substrate 200. That is, when the orthographic projection of the second break 3321b1 on the substrate 200 and the orthographic projection of the second bent portion 3222 on the substrate 200 are compared, the two projections overlap in the fourth direction X4. Alternatively, this can be understood as that, as shown in FIG. 26 and FIG. 27, in a plan view (top view) ignoring the positional relationship between layers accommodating the second dummy auxiliary sub-line 3321b and the second bent portion 3222, the orthographic projection of the second bent portion 3222 overlaps the orthographic projection of the second break 3321b1 in the fourth direction X4. That is, the second dummy auxiliary sub-line 3321b is similar to the first dummy auxiliary sub-line 3321a. The first dummy auxiliary sub-line 3321a has the first break 310a. The second dummy auxiliary sub-line 3321b is also broken. The second dummy auxiliary sub-line 3321b has the second break 3321b1.

In embodiments, the second dummy auxiliary sub-line 3321b in the main display region AA1 is also broken. When manufactured, all the first dummy auxiliary lines 3321 are broken, that is, the first dummy auxiliary line 3321 in the main display region AA1 is broken (i.e., provided with the first break 310a), and the first dummy auxiliary line 3321 in the auxiliary display region AA2 is broken (i.e., provided with the second break 3321b1). In this manner, the first dummy auxiliary lines 3321 are arranged in the same or similar manner, thereby reducing the difficulty in manufacturing the first dummy auxiliary lines 3321, that is, reducing the difficulty in manufacturing the wiring of the display panel 10.

In embodiments, in the comparison between FIG. 26 and FIG. 11 or between FIG. 27 and FIG. 12, for the auxiliary display region AA2, to improve the transmittance of this region and reduce light blocking by lines, that is, to increase the light transmittance of the light-transmissive aperture 100, the second dummy auxiliary sub-line 3321a is broken by a first break 310a. For the main display region AA1, although the light transmittance of the display panel 10 is not a concern, to ensure the wiring uniformity, the second dummy auxiliary sub-line 3321b may also be broken to reduce the difficulty in manufacturing the display panel 10.

With continued reference to FIG. 27, in the third direction X3, the orthographic projection of the second bent portion 3222 on the substrate 200 overlaps the orthographic projection of the second dummy auxiliary sub-line 3321b on the substrate 200.

By way of example, in the third direction X3, the orthographic projection of the second bent portion 3222 on the substrate 200 overlaps the orthographic projection of the second dummy auxiliary sub-line 3321b on the substrate 200. That is, when the orthographic projection of the second bent portion 3222 on the substrate 200 and the orthographic projection of the second dummy auxiliary sub-line 3321b on the substrate 200 are compared, the two projections overlap with each other in the third direction X3. Alternatively, this can be understood that, as shown in FIG. 23, the second bent portion 3222 can extend to the second break 3321b1 of the second dummy auxiliary sub-line 3321b, so that in the third direction X3, the orthogonal projection of the second bent portion 3222 on the substrate 200 overlaps the orthogonal projection of the second dummy auxiliary sub-line 3321b on the substrate 200.

In embodiments, at the auxiliary display region AA2, as shown in FIG. 12, part of the first data signal line 321 may extend to the first break 310a, thus effectively increasing the light transmittance of the light-transmissive aperture 100 and improving the overall light transmittance of the display panel 10. To ensure the wiring uniformity, at the main display region AA1, as shown in FIG. 27, part of the second data signal line 322 may also extend to the second break 3321b1, ensuring the neatness of the wiring on the display panel 10.

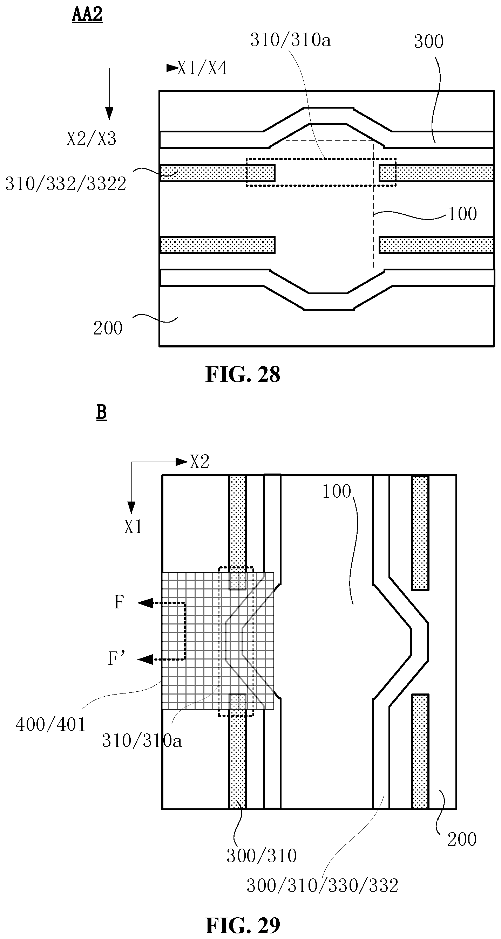

FIG. 28 is an eighth enlarged view of an auxiliary display region according to embodiments of this application. Referring to FIG. 9 and FIG. 28, the data auxiliary line 331 include a first data auxiliary line 3311 and a second data auxiliary line 3312 electrically connected to each other, the first data auxiliary line 3311 extends in the third direction X1 and is electrically connected to the fan-out line S0, and the second data auxiliary line 3312 extends in the fourth direction X4 and is electrically connected to the data signal line 320. The dummy auxiliary line 332 include a first dummy auxiliary line 3321 and a second dummy auxiliary line 3322 connected to each other, the first dummy auxiliary lines 3321 extend in the third direction X1, and the second dummy auxiliary line 3322 extends in the fourth direction X4. The first dummy auxiliary line 3321 and the first data auxiliary line 3311 are disposed in the same layer and insulated from each other, and the second dummy auxiliary line 3322 and the second data auxiliary line 3312 are disposed in the same layer and insulated from each other. The first signal line 310 includes at least part of the second dummy auxiliary line 3322. The first direction X1 and the fourth direction X4 are the same direction, and the second direction X2 and the third direction X3 are the same direction.

Similarly, as shown in FIG. 9, the data auxiliary line 331 includes the first data auxiliary line 3311 and the second data auxiliary line 3312 electrically connected to each other. The extension direction of the first data auxiliary line 3311 is the same as the extension direction of the data signal line 320. The extension direction of the second data auxiliary line 3312 intersects the extension direction of the data signal line 320. A subset of the data signal lines 320 in region B2 of FIG. 9 are first electrically connected to the second data auxiliary lines 3312 extending in the fourth direction X4. The second data auxiliary lines 3312 are electrically connected to the first data auxiliary lines 3311 extending in the third direction X3. The first data auxiliary lines 3311 are electrically connected to the fan-out lines S0 in the fan-out region A1. This enables data signals in the fan-out lines S0 to be transmitted to the data signal lines 320 through the data auxiliary lines 331.

In embodiments, as shown in FIG. 9, the dummy auxiliary line 332 includes the first dummy auxiliary line 3321 and the second dummy auxiliary line 3322 electrically connected to each other. The first dummy auxiliary line 3321 extends in the same direction as the first data auxiliary line 3311. The first dummy auxiliary line 3321 is insulated from the first data auxiliary line 3311. The second dummy auxiliary line 3322 extends in the same direction as the second data auxiliary line 3311. The second dummy auxiliary line 3322 is insulated from the second data auxiliary line 3312. With the first dummy auxiliary line 3321 and the first data auxiliary line 3311, the wiring arrangement of the display panel 10 can be balanced in both the third direction X3 and the fourth direction X4, ensuring that the wiring density is uniform across different regions. This prevents an unbalanced display effect of the display panel 10 due to different light reflectivities across the display panel 10 caused by unbalanced wiring.

In embodiments, in combination with FIG. 28, the fourth direction X3 may be the same as the first direction X1, and the third direction X3 may be the same as the second direction X2. In this case, the first signal lines 310 can be understood as extending in the fourth direction X4. The second dummy auxiliary line 3322 is a dummy auxiliary line 332 and extends in the fourth direction X4. Therefore, the second dummy auxiliary line 3322 can be at least partially located in the auxiliary display region AA2. Thus, the first signal line 310 includes at least part of the second dummy auxiliary line 3322. That is, the first signal line 310 includes the part of the second dummy auxiliary line 3322 which is located in the auxiliary display region AA2. In embodiments, that the second dummy auxiliary line 3322 is configured as the first signal line 310 in a similar manner in which the first dummy auxiliary line 3321 is configured as the first signal line 310, which is not repeated here in embodiments for the second dummy auxiliary line 3322.

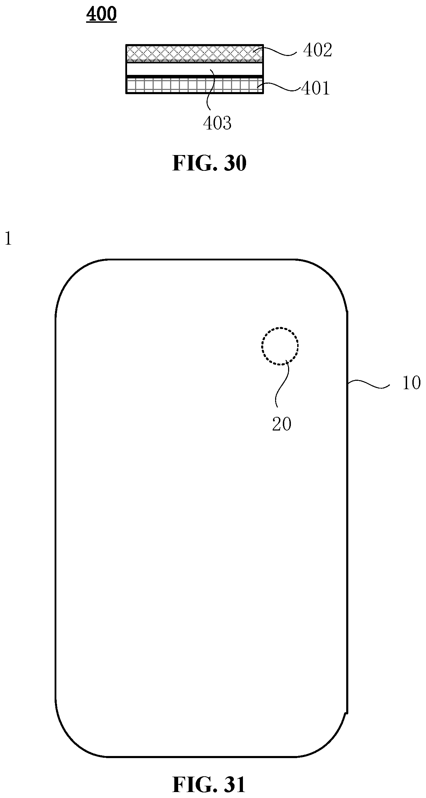

FIG. 29 is an enlarged view of region B of FIG. 1. FIG. 30 is a section view taken along line F-F' of FIG. 29. As shown in FIG. 1, FIG. 29, and FIG. 30, the display panel 10 includes multiple light-emitting elements 400. The light-emitting element 400 includes a first electrode 401, a second electrode 402, and a light-emitting layer 403 located between the first electrode 401 and the second electrode 402. In the thickness direction of the display panel 10, the first electrode 401 overlaps the first break 310a.

With reference to FIG. 1 and FIG. 29, the display panel 10 includes multiple light-emitting elements 400 for performing the display function of the display panel 10. In embodiments, with reference to FIG. 30, the light-emitting element 400 includes a first electrode 401, a second electrode 402, and a light-emitting layer 403. The first electrode 401 is located on the side of the second electrode 402 facing the substrate 200. The light-emitting layer 403 is located between the first electrode 401 and the second electrode 402.

In embodiments, as shown in FIG. 29, in the thickness direction of the display panel 10, the first electrode 401 covers the first break 310a. It is noted that the second electrode 402 and the light-emitting layer 403 may be arranged across the entire surface. FIG. 25 shows the first electrode 401 of the light-emitting element 400, and does not show the second electrode 402 and the light-emitting layer 403. The first electrode 401 covers the first break 310a, that is, the first electrode 401 blocks the break of the line, preventing color shift in light transmission caused by the break, and ensuring the overall display effect of the display panel 10. The first electrode 401 blocks the first break 310a, improving the flatness of the display panel 10.

Based on the same inventive concept, embodiments of this application also provide a display device. FIG. 31 is a diagram illustrating the structure of a display device according to embodiments of this application. As shown in FIG. 31, the display device 1 includes the display panel 10 according to any of the foregoing embodiments. Therefore, the display device 1 of embodiments of this application has the corresponding beneficial effects in the foregoing embodiments, which are not repeated herein. In embodiments, the display device 1 also includes a photosensitive element 20. In the thickness direction of the display device 10, the light-transmissive aperture overlaps the photosensitive element 20. By way of example, the display device 1 may be an electronic device such as a mobile phone, a computer, a smart wearable device (for example, a smartwatch), or an in-vehicle display device; and the photosensitive element 20 may be an under-screen camera, a fingerprint identification module, or an ambient light sensor, which is not limited in embodiments of this application. It is noted that the number of photosensitive elements 20 disposed in the display device 1 may vary. In FIG. 31, only one photosensitive element 20 is illustrated. Alternatively, it may be understood that FIG. 31 illustrates a region in which at least one photosensitive element is disposed. The photosensitive elements 20 may be configured adaptively based on the configuration of the display device 1.

## Claims

1. A display panel, comprising a display region and a non-display region, wherein
the non-display region at least partially surrounds the display region;
the display region comprises a main display region and an auxiliary display region, the main display region at least partially surrounds the auxiliary display region, and the auxiliary display region comprises a light-transmissive aperture through which light is allowed to pass to a photosensitive element; and
the display panel further comprises a substrate and a plurality of signal lines, the plurality of signal lines comprise a first signal line, the first signal line extends in a first direction, the first signal line comprises a first break, and in a second direction, an orthographic projection of the first break on the substrate overlaps an orthographic projection of the light-transmissive aperture on the substrate;
wherein the first direction intersects the second direction.

2. The display panel of claim 1, wherein
the plurality of signal lines further comprise a plurality of data signal lines, the plurality of data signal lines extend in a third direction and are arranged in a fourth direction, and the third direction intersects the fourth direction;
the plurality of signal lines further comprise a plurality of auxiliary lines;
the non-display region comprises a fan-out region located on one side of the display region, and the fan-out region comprises a plurality of fan-out lines;
the plurality of auxiliary lines comprise a data auxiliary line, at least part of the data auxiliary line is located in the display region, and at least a subset of the plurality of data signal lines are electrically connected to the plurality of fan-out lines through the data auxiliary lines;
the plurality of auxiliary lines further comprise a dummy auxiliary line located in the display region, and the dummy auxiliary line and the data auxiliary line are disposed in a same layer and insulated from each other; and
the first signal line comprises the dummy auxiliary line.

3. The display panel of claim 2, wherein
the data auxiliary line comprises a first data auxiliary line and a second data auxiliary line electrically connected to each other, the first data auxiliary line extends in the third direction and is electrically connected to a fan-out line of the plurality of fan-out lines, and the second data auxiliary line extends in the fourth direction and is electrically connected to a data signal line of the plurality of data signal lines;
the dummy auxiliary line comprises a first dummy auxiliary line and a second dummy auxiliary line connected to each other, the first dummy auxiliary line extends in the third direction, the second dummy auxiliary line extends in the fourth direction, the first dummy auxiliary line and the first data auxiliary line are disposed in a same layer and insulated from each other, and the second dummy auxiliary line and the second data auxiliary line are disposed in a same layer and insulated from each other; and
the first signal line comprises at least part of the first dummy auxiliary line, the first direction and the third direction are a same direction, and the second direction and the fourth direction are a same direction.

4. The display panel of claim 3, wherein
the plurality of data signal lines comprise a first data signal line, and at least part of the first data signal line is located in the auxiliary display region;
the first dummy auxiliary line comprises a first dummy auxiliary sub-line, and at least part of the first dummy auxiliary sub-line is located in the auxiliary display region; and
the first data signal line is adjacent to the first dummy auxiliary sub-line.

5. The display panel of claim 4, wherein
the first data signal line is located on a side of the first dummy auxiliary sub-line facing the light-transmissive aperture;
the first data signal line comprises a first main portion and a first bent portion electrically connected to each other, and in the fourth direction, an orthographic projection of the first bent portion on the substrate overlaps the orthographic projection of the light-transmissive aperture on the substrate; and
in the third direction, the orthographic projection of the first bent portion on the substrate overlaps an orthographic projection of the first dummy auxiliary sub-line on the substrate.

6. The display panel of claim 4, wherein
the first data signal line is located on a side of the first dummy auxiliary sub-line facing the light-transmissive aperture;
the first data signal line comprises a first main portion and a first bent portion electrically connected to each other, and in the fourth direction, an orthographic projection of the first bent portion on the substrate overlaps the orthographic projection of the light-transmissive aperture on the substrate; and
in the third direction, the orthographic projection of the first bent portion on the substrate is non-overlapping with an orthographic projection of the first dummy auxiliary sub-line on the substrate.

7. The display panel of claim 4, wherein
the first data signal line is located on a side of the first dummy auxiliary sub-line facing away from the light-transmissive aperture, and in a thickness direction of the display panel, the first break overlaps the light-transmissive aperture.

8. The display panel of claim 4, wherein
the first dummy auxiliary sub-line comprises a first line segment and a second line segment respectively located on two sides of the first break; and
a plurality of first line segments arranged in the fourth direction are electrically connected to each other through the second dummy auxiliary line; and/or
a plurality of second line segments arranged in the fourth direction are electrically connected to each other through the second dummy auxiliary line.

9. The display panel of claim 8, further comprising a signal bus located in the non-display region, wherein
the second dummy auxiliary line is electrically connected to the signal bus; and
the signal bus is located on at least one side of the display region in the fourth direction.

10. The display panel of claim 8, wherein
the second dummy auxiliary line is configured to receive a fixed-potential signal.

11. The display panel of claim 10, wherein
the fixed-potential signal comprises a power signal, an initialization signal, or a bias adjustment signal.

12. The display panel of claim 3, wherein
the plurality of data signal lines comprise a second data signal line located in the main display region, and the second data signal line comprises a second main portion and a second bent portion electrically connected to each other.

13. The display panel of claim 12, wherein
the plurality of data signal lines comprise a first data signal line, and at least part of the first data signal line is located in the auxiliary display region;
the first data signal line comprises a first main portion and a first bent portion electrically connected to each other, and in the fourth direction, an orthographic projection of the first bent portion on the substrate overlaps the orthographic projection of the light-transmissive aperture on the substrate;
two adjacent first data signal lines comprise two adjacent first bent portions, respectively, and a distance between the two adjacent first bent portions is L1;
two adjacent second data signal lines comprise two adjacent second bent portions, respectively, and a distance between the two adjacent second bent portions is L2; and $L 1 \geq L 2 .$

14. The display panel of claim 12, wherein
the first dummy auxiliary line comprises a second dummy auxiliary sub-line located in the main display region; and
the second dummy auxiliary sub-line is adjacent to the second data signal line.

15. The display panel of claim 14, wherein
in the fourth direction, an orthographic projection of the second dummy auxiliary sub-line on the substrate overlaps an orthographic projection of the second bent portion on the substrate.

16. The display panel of claim 14, wherein
the second dummy auxiliary sub-line comprises a second break; and
in the fourth direction, an orthographic projection of the second break on the substrate overlaps an orthographic projection of the second bent portion on the substrate.

17. The display panel of claim 16, wherein
in the third direction, the orthographic projection of the second bent portion on the substrate overlaps an orthographic projection of the second dummy auxiliary sub-line on the substrate.

18. The display panel of claim 2, wherein
the data auxiliary line comprises a first data auxiliary line and a second data auxiliary line electrically connected to each other, the first data auxiliary line extends in the third direction and is electrically connected to a fan-out line of the plurality of fan-out lines, and the second data auxiliary line extends in the fourth direction and is electrically connected to a data signal line of the plurality of data signal line;
the dummy auxiliary line comprises a first dummy auxiliary line and a second dummy auxiliary line connected to each other, the first dummy auxiliary line extends in the third direction, the second dummy auxiliary line extends in the fourth direction, the first dummy auxiliary line and the first data auxiliary line are disposed in a same layer and insulated from each other, and the second dummy auxiliary line and the second data auxiliary line are disposed in a same layer and insulated from each other; and
the first signal line comprises at least part of the second dummy auxiliary line, the first direction and the fourth direction are a same direction, and the second direction and the third direction are a same direction.

19. The display panel of claim 1, comprising a plurality of light-emitting elements, wherein
a light-emitting element of the plurality of light-emitting elements comprises a first electrode, a second electrode, and a light-emitting layer located between the first electrode and the second electrode; and
in a thickness direction of the display panel, the first electrode overlaps the first break.

20. A display device, comprising the display panel of any one of claims 1 to 19 and the photosensitive element, wherein
in a thickness direction of the display device, the light-transmissive aperture overlaps the photosensitive element.
